(19) **Europäisches Patentamt / European Patent Office / Office européen des brevets**

(11) **EP 3 151 265 B1**

(12) **FASCICULE DE BREVET EUROPEEN**

(45) Date de publication et mention
de la délivrance du brevet:
**28.02.2018 Bulletin 2018/09**

(51) Int Cl.:
**H01L 21/02** *(2006.01)*    **H01S 5/32** *(2006.01)*
**H01S 5/125** *(2006.01)*    **H01L 33/34** *(2010.01)*
**H01S 5/02** *(2006.01)*

(21) Numéro de dépôt: **16190978.3**

(22) Date de dépôt: **28.09.2016**

(54) **PROCEDE DE REALISATION D'UNE STRUCTURE SEMICONDUCTRICE COMPORTANT UNE PORTION CONTRAINTE**

HERSTELLUNGSVERFAHREN EINER HALBLEITERSTRUKTUR, DIE EINEN SPANNABSCHNITT UMFASST

METHOD FOR PRODUCING A SEMICONDUCTOR STRUCTURE COMPRISING A STRESSED PORTION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **30.09.2015 FR 1559283**

(43) Date de publication de la demande:
**05.04.2017 Bulletin 2017/14**

(73) Titulaire: **Commissariat à l'énergie atomique et aux énergies alternatives**
**75015 Paris (FR)**

(72) Inventeurs:
• **GASSENQ, Alban**
**30560 SAINT-HILAIRE (FR)**
• **REBOUD, Vincent**
**75013 PARIS (FR)**
• **GUILLOY, Kévin**
**38000 GRENOBLE (FR)**
• **CALVO, Vincent**
**38600 FONTAINE (FR)**
• **TCHELNOKOV, Alexei**
**38240 MEYLAN (FR)**

(74) Mandataire: **GIE Innovation Competence Group**
**310, avenue Berthelot**
**69372 Lyon Cedex 08 (FR)**

(56) Documents cités:
• **BOZTUG CICEK ET AL: "Grating-coupled mid-infrared light emission from tensilely strained germanium nanomembranes", APPLIED PHYSICS LETTERS, A I P PUBLISHING LLC, US, vol. 103, no. 20, 11 novembre 2013 (2013-11-11), XP012178797, ISSN: 0003-6951, DOI: 10.1063/1.4830377 [extrait le 1901-01-01]**

**Description**

**DOMAINE TECHNIQUE**

Le domaine de l'invention est celui de la réalisation d'une structure semiconductrice, comportant une portion contrainte, solidarisée à une couche support par collage moléculaire. L'invention s'applique en particulier à la réalisation d'un dispositif optoélectronique apte à émettre ou recevoir de la lumière et comportant une telle structure semiconductrice à portion contrainte. Le dispositif optoélectronique peut être, à titre illustratif, une source laser dont le milieu à gain est formé d'une portion de germanium contraint, disposé sur un circuit photonique à base de silicium.

**ÉTAT DE LA TECHNIQUE ANTÉRIEURE**

Dans diverses applications électroniques ou optoélectroniques, il peut être avantageux d'utiliser une couche d'un matériau monocristallin contraint, telle qu'une couche de silicium, de silicium germanium, de germanium étain, voire de germanium. C'est le cas notamment des transistors haute performance où la contrainte subie par un matériau se traduit par une augmentation de la vitesse de déplacement des porteurs de charge, ce qui améliore ainsi les performances d'un tel transistor. C'est le cas également de certaines sources de lumière dont le matériau de la couche émissive présente, hors contrainte, une structure de bandes d'énergie indirecte, la structure de bandes étant alors rendue sensiblement directe par l'application d'une contrainte adéquate.

L'article de Sukhdeo et al. intitulé Direct bandgap germanium-on-silicon inferred from 5,7% <100> uniaxial tensile strain, Photon. Res. Vol. 2, No. 3, A8, 2014 décrit un exemple d'une partie structurée d'une couche semiconductrice adaptée à émettre de la lumière, la partie structurée comportant une portion contrainte de germanium suspendue au-dessus d'une couche support en silicium. La partie structurée comporte également des portions latérales, ou bras tenseurs, reliant la portion contrainte à une partie périphérique de la couche semiconductrice, et assurant la mise en tension de la portion contrainte.

Le procédé de réalisation d'une telle partie structurée de la couche semiconductrice consiste tout d'abord à obtenir un substrat de type GOI (pour Germanium On Insulator, en anglais) où une couche semiconductrice de germanium monocristallin, réalisée préalablement par épitaxie, est collée à une couche sacrificielle d'oxyde de silicium qui s'étend sur une couche support de silicium. La couche semiconductrice de germanium présente, à température ambiante, une contrainte résiduelle en tension se traduisant par une déformation du réseau cristallin du germanium de l'ordre de 0,2%. La couche de germanium est ensuite structurée de manière à former une portion centrale sous forme d'un fil relié à une partie périphérique de la couche de germanium par deux portions latérales, également appelées bras tenseurs, agencées mutuellement de manière à générer dans la portion centrale une contrainte en tension uniaxiale. Une cavité est ensuite réalisée sous la partie structurée par gravure de la couche sacrificielle de manière à rendre libre la surface de la couche support située en regard de la partie structurée. On obtient ainsi une membrane suspendue dans laquelle les portions latérales induisent une contrainte en tension dans la partie centrale, induisant une déformation uniaxiale de l'ordre de 5,7%, réduisant, voire inversant, l'écart entre les bandes interdites directes et indirectes. Dans le but d'assurer un contact thermique entre la portion contrainte et la couche support, la partie structurée est mise au contact de la surface libre de la couche support.

Cependant, il existe un besoin pour réaliser une structure semiconductrice à partir de la partie structurée de la couche semiconductrice, c'est-à-dire une structure semiconductrice qui puisse être individualisée, c'est-à-dire séparée de la partie périphérique de la couche semiconductrice, sans que sa tenue mécanique et donc ses propriétés électroniques et/ou optiques soient dégradées. Il existe également un besoin pour obtenir une structure semiconductrice qui puisse supporter des étapes ultérieures classiques de microélectronique, telles que des étapes de dépôt de couche, de lithographie et de gravure. Il existe enfin un besoin pour être en mesure de réaliser de manière collective et simultanée une pluralité de structures semiconductrices adjacentes et distinctes les unes des autres.

L'article de Botzug et al, "Grating-coupled mis-infrared light émission from tensilely strained germanium nanomembranes", in Applied Physics Letters, vol. 103 (2013), n° 201114, décrit également un état de la technique relevant pour la présente invention.

**EXPOSÉ DE L'INVENTION**

L'invention a pour objectif de remédier au moins en partie aux inconvénients de l'art antérieur, et plus particulièrement de proposer un procédé de réalisation d'une structure semiconductrice comportant une portion contrainte et collée à une couche support. Pour cela, l'objet de l'invention est un procédé de réalisation d'une structure semiconductrice comportant une portion contrainte et solidaire d'une couche support par collage moléculaire, comportant les étapes dans lesquelles :

i. on fournit un empilement formé d'une couche semiconductrice recouvrant une couche sacrificielle disposée sur une couche support ;

ii. on structure la couche semiconductrice de manière à former une partie structurée et une partie périphérique, la partie structurée comportant une portion centrale reliée à la partie périphérique par au moins deux portions latérales opposées l'une à l'autre vis-à-vis de la portion centrale ;

iii. on réalise une cavité située sous la partie structurée par gravure de la couche sacrificielle, de manière à rendre libre une surface de la couche support située au niveau de la cavité et à contraindre la portion centrale, dite portion contrainte, par les portions latérales, ainsi qu'une mise en contact de la partie structurée avec ladite surface libre de manière à rendre solidaire la partie structurée de ladite surface libre par collage moléculaire ;

le procédé étant caractérisé en ce que :

iv. on détermine une valeur minimale d'énergie de collage moléculaire de la partie structurée sur la couche support, ainsi qu'une valeur minimale de surface collée des portions latérales sur la couche support, ces valeurs minimales étant telles que ladite énergie de collage moléculaire est supérieure à une énergie élastique de la partie structurée ;

v. on effectue un recuit de consolidation à une température de recuit telle que l'énergie de collage moléculaire présente une valeur supérieure ou égale à ladite valeur minimale préalablement déterminée ;

vi. on grave une partie distale des portions latérales vis-à-vis de la portion contrainte, de sorte que la surface collée des portions latérales présente une valeur supérieure ou égale à ladite valeur minimale préalablement déterminée, obtenant ainsi ladite structure semiconductrice.

Certains aspects préférés mais non limitatifs de ce procédé de réalisation sont les suivants :

La gravure de la couche sacrificielle lors de la réalisation de la cavité s'entend comme une gravure partielle, et non totale, de la couche sacrificielle, au travers d'ouvertures formées dans la couche semiconductrice lors de la réalisation de la partie structurée. Plus précisément, on grave la partie de la couche sacrificielle située sous la partie structurée.

Lors de l'étape vi, on peut graver une partie distale des portions latérales formant raccord avec la partie périphérique de la couche semiconductrice.

A la suite de l'étape vi, la structure semiconductrice peut présenter une face supérieure opposée à la couche support sensiblement plane.

La couche semiconductrice comportant un matériau présentant, hors contrainte, une structure de bandes d'énergie indirecte, on peut structurer les portions latérales lors de l'étape ii de sorte que, lors de l'étape iii, la portion contrainte présente une déformation telle que le matériau formant la portion contrainte ait une structure de bandes d'énergie sensiblement directe.

Le procédé peut comporter les étapes suivantes :

- préalablement à l'étape i) de fourniture de l'empilement, estimation d'une valeur minimale de contrainte en tension à partir de laquelle la couche semiconductrice présente une structure de bandes d'énergie directe ;
- fourniture dudit empilement, la couche semiconductrice présentant une valeur initiale inférieure à ladite valeur minimale ;
- détermination de la structuration de sorte que, après l'étape iii) de réalisation de la cavité, la portion centrale de la partie structurée présente une valeur finale de contrainte en tension supérieure ou égale à ladite valeur minimale et donc une structure de bandes d'énergie directe.

Lors de la fourniture dudit empilement, la couche semiconductrice peut présenter une contrainte en tension d'une valeur initiale non nulle. De plus, lors de l'étape de structuration, les portions latérales de la partie structurée peuvent présenter une largeur moyenne supérieure à une largeur moyenne de la portion centrale. Ainsi, lors de la réalisation de la cavité, la portion centrale peut présenter une valeur finale de contrainte supérieure à la valeur initiale.

Lors de l'étape iii, on peut réaliser la cavité et la mise en contact par gravure par HF en phase vapeur éventuellement suivie par le dépôt puis l'évaporation d'un liquide au niveau de la cavité, et dans lequel, lors de l'étape v la température de recuit est sensiblement supérieure ou égale à 200°C.

Lors de l'étape iii, on peut réaliser une oxydation ou une nitruration de ladite surface libre et d'une surface de la partie structurée orientée vers la surface libre, et dans lequel, lors de l'étape v la température de recuit est sensiblement supérieure ou égale à 100°C.

Une couche diélectrique issue de ladite oxydation ou nitruration peut être formée à l'interface entre la partie structurée et la couche support, dont l'épaisseur est de préférence supérieure ou égale à 10nm.

Lors de l'étape ii, on peut structurer les portions latérales de sorte que, lors de l'étape iii, la portion contrainte présente une déformation uniaxiale ou biaxiale.

La portion contrainte peut comporter au moins une partie dopée avec un niveau de dopage supérieur ou égal à $2.10^{18}$ cm$^{-3}$.

On peut réaliser au moins un élément de renfort situé au niveau de la portion contrainte, ledit élément de renfort comportant un matériau distinct du matériau formant la portion contrainte, et s'étendant sur toute l'épaisseur de la portion contrainte et dans une partie de la couche support.

L'invention porte également sur un procédé de réalisation collective d'une pluralité de structures semiconductrices adjacentes et distinctes les unes des autres, dans lequel on réalise de manière simultanée lesdites structures semiconductrices par le procédé de réalisation selon l'une quelconque des caractéristiques précédentes, et dans lequel on sépare chaque structure semiconductrice de la partie périphérique correspondante.

L'invention porte également sur un procédé de réalisation d'un dispositif optoélectronique, ledit dispositif comportant une structure semiconductrice obtenue par le procédé selon l'une quelconque des caractéristiques précédentes, dans lequel on réalise une jonction PN ou PIN dans la portion contrainte, la jonction s'étendant de manière sensiblement orthogonale ou parallèle au plan de la couche support.

On peut réaliser une cavité optique dans laquelle est située au moins une partie de la portion contrainte dont le matériau est adapté à former un milieu à gain, le dispositif obtenue étant adapté à émettre un faisceau lumineux cohérent.

On peut réaliser au moins deux éléments optiques réflecteurs adaptés à former la cavité optique, les éléments optiques étant disposés au niveau d'une face supérieure de la structure semiconductrice opposée à la couche support.

On peut réaliser au moins deux éléments optiques réflecteurs adaptés à former la cavité optique, les éléments optiques étant disposés au niveau de la surface libre de la couche support.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

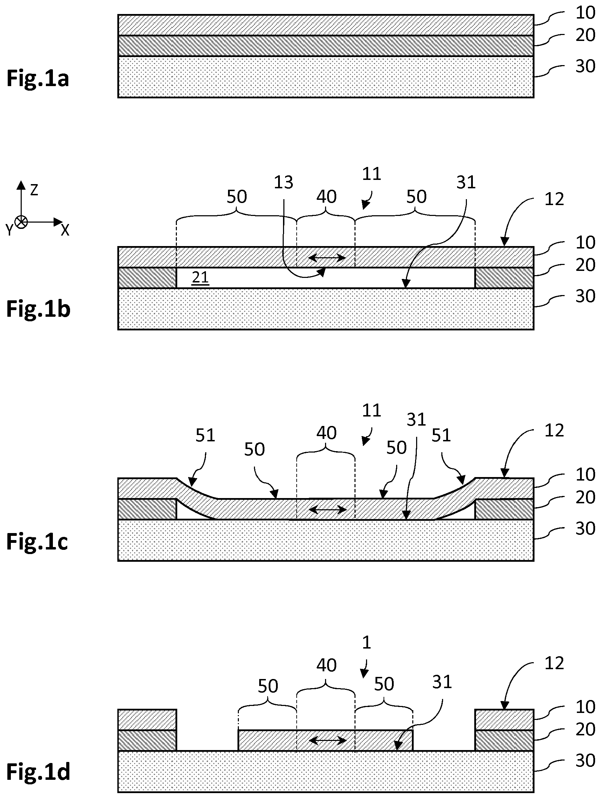

les figures 1a à 1d illustrent, de manière schématique et en vue en coupe, différentes étapes d'un procédé de réalisation d'une structure semiconductrice à portion contrainte, collée à une couche support par adhérence moléculaire hydrophobe ;

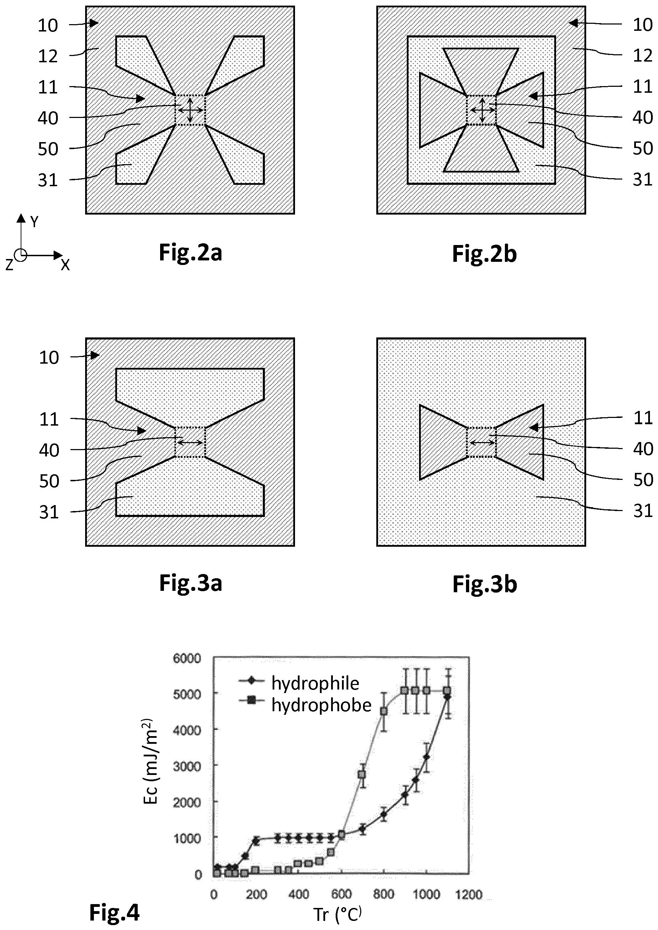

la figure 2a illustre de manière schématique et en vue de dessus une partie structurée collée sur une couche support et comportant une portion contrainte subissant une déformation biaxiale, et la figure 2b illustre la partie structurée séparée d'une partie périphérique de la couche semiconductrice ;

la figure 3a illustre de manière schématique et en vue de dessus une partie structurée collée sur une couche support et comportant une portion contrainte subissant une déformation uniaxiale, et la figure 3b illustre la partie structurée séparée d'une partie périphérique de la couche semiconductrice ;

la figure 4 illustre un exemple de relation entre l'énergie surfacique de collage hydrophile et hydrophobe entre la partie structurée et la couche support en fonction d'une température de recuit ;

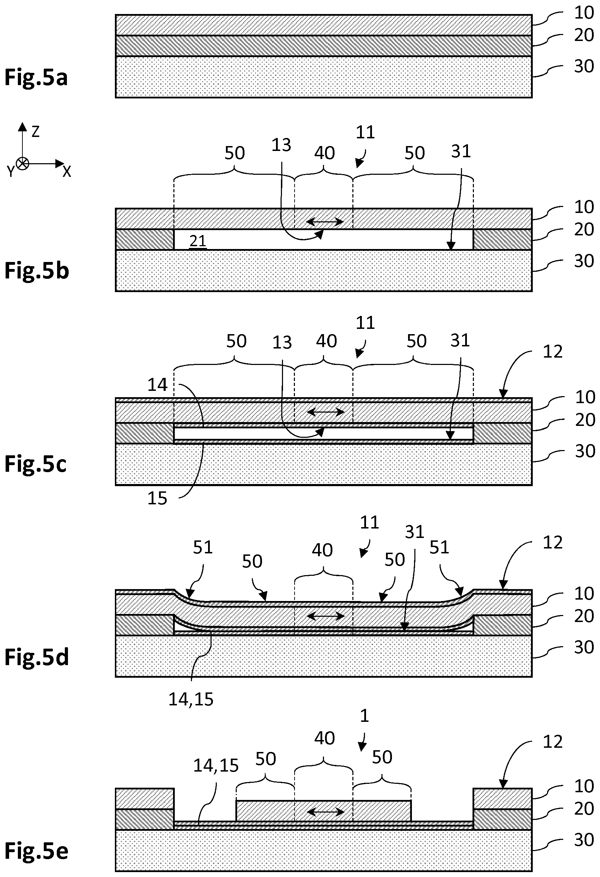

les figures 5a à 5e illustrent, de manière schématique et en vue en coupe, différentes étapes d'un procédé de réalisation d'une structure semiconductrice à portion contrainte, collée à une couche support par adhérence moléculaire hydrophile ;

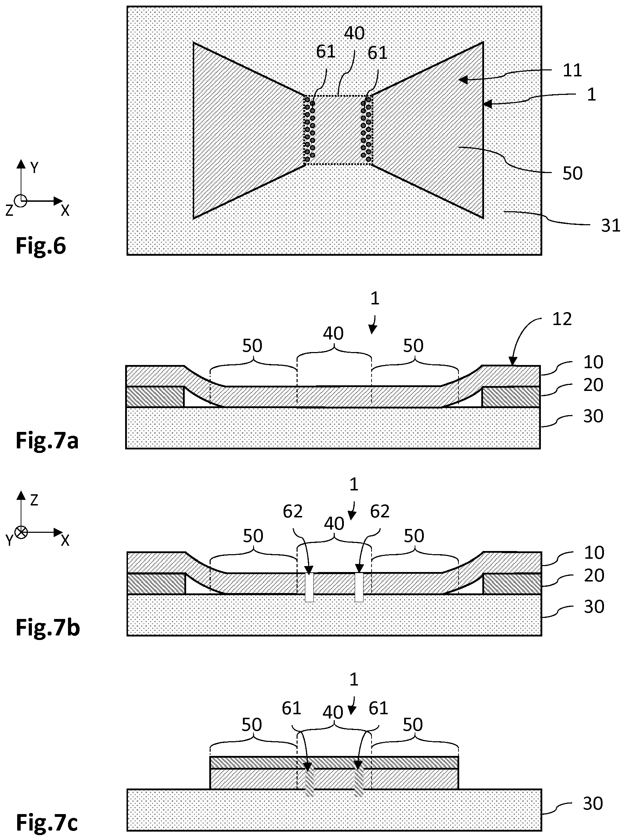

les figures 6 et 7a à 7c illustrent de manière schématique un exemple de structure semiconductrice comportant des éléments de renfort, la figure 6 représentant une telle structure en vue de dessus et les figures 7a et 7c représentent différentes étapes de réalisation de la structure en vue en coupe ;

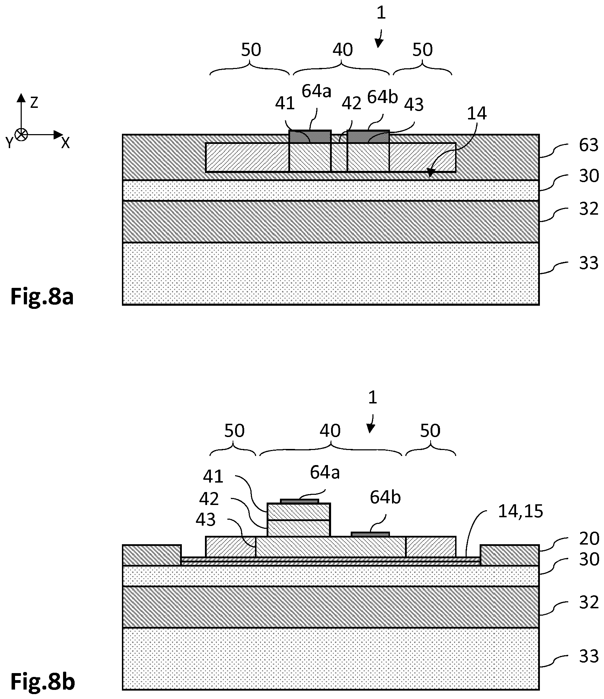

les figures 8a et 8b illustrent de manière schématique et en vue en coupe deux exemples de dispositif optoélectronique comportant une structure semiconductrice obtenue par le procédé selon l'invention, le dispositif optoélectronique étant ici une diode électroluminescente comportant une jonction PIN orientée de manière verticale (figure 8a) ou horizontale (figure 8b) ;

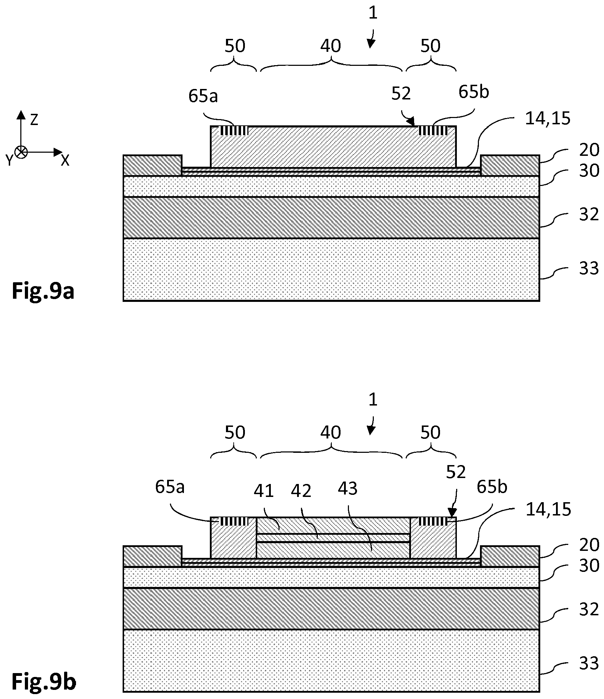

les figures 9a et 9b illustrent de manière schématique et en vue en coupe deux exemples de dispositif optoélectronique comportant une structure semiconductrice obtenue par le procédé selon l'invention, le dispositif optoélectronique étant ici une source laser où une cavité optique est réalisée dans la structure semiconductrice, la portion contrainte comportant une jonction PIN (figure 9b) ou non (figure 9a) ;

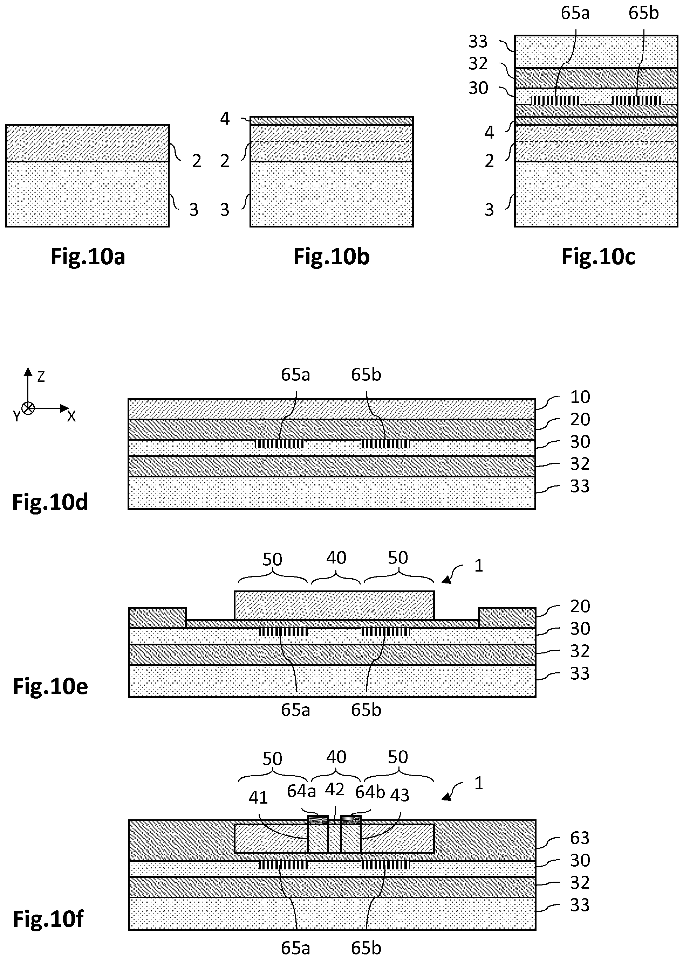

les figures 10a à 10f illustrent de manière schématique et en vue en coupe différentes étapes d'un procédé de réalisation d'un dispositif optoélectronique comportant une structure semiconductrice obtenue par le procédé selon l'invention, le dispositif optoélectronique étant ici une source laser où une cavité optique est réalisée dans la couche support ;

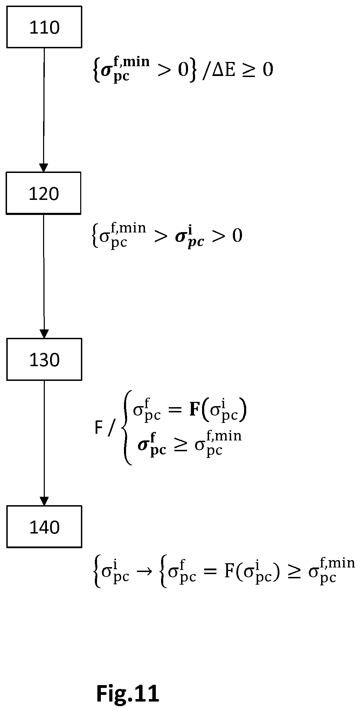

la figure 11 est un organigramme d'un procédé selon un mode de réalisation permettant d'obtenir une portion centrale d'une couche semiconductrice à structure de bandes directe.

## EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures.

L'invention concerne d'une manière générale un procédé de réalisation d'une structure semiconductrice, comportant une portion contrainte à base d'un matériau monocristallin, solidarisée par collage direct à une surface d'une couche support.

La structure semiconductrice est avantageusement réalisée à base d'un matériau semiconducteur monocristallin dont la structure de bandes d'énergie est indirecte lorsque le matériau est non contraint ou relaxé, c'est-à-dire que le maximum de la bande de valence et le minimum de la bande de conduction ne correspondent pas à la même valeur du vecteur d'onde. Le matériau de la portion contrainte de la structure semiconductrice peut alors présenter une déformation de son réseau cristallin suffisante pour rendre sensiblement directe la structure de bandes. Par structure de bandes sensiblement directe, on entend que la différence d'énergie entre le minimum de la vallée $\Gamma$ (ou vallée directe) et le minimum de la vallée L (ou vallée indirecte) de la bande de conduction est de l'ordre de grandeur ou inférieure à kT, où k est la constante de Boltzmann et T la température du matériau. Autrement dit, par structure de bandes directe ou sensiblement directe, on entend que le minimum d'énergie de la vallée L (ou vallée indirecte) est supérieur ou sensiblement égal au minimum d'énergie de la vallée $\Gamma$ (ou vallée directe) de la bande de conduction : $\Delta E = E_{min,L} - E_{min,\Gamma} \geq 0$. Par sensiblement égal, on entend ici que cette différence d'énergie est de l'ordre de grandeur ou inférieure à kT, où k est la constante de Boltzmann et T la température du matériau.

Un mode de réalisation préféré de l'invention porte plus particulièrement sur une structure semiconductrice de germanium monocristallin comportant une portion contrainte en tension dont la déformation est suffisante pour présenter une structure de bandes sensiblement directe, la structure semiconductrice étant collée par adhérence moléculaire à la surface d'une couche support de silicium.

Par portion contrainte, on entend une portion réalisée en un matériau semiconducteur monocristallin présentant une contrainte mécanique en tension ou en compression, entraînant une déformation des mailles du réseau cristallin du matériau semiconducteur. La portion contrainte présente alors une énergie élastique Ee, qui, au premier ordre, peut s'écrire : $Ee \sim E.\varepsilon^2.V$, où E est le module d'Young du matériau semiconducteur qui dépend notamment du caractère uniaxial ou biaxial, voire multiaxial, de la déformation du matériau ainsi que de l'axe cristallin de la déformation, $\varepsilon$ la déformation moyenne subie par le matériau, et V le volume de la portion. Dans le cadre de l'invention, la portion contrainte présente ici une contrainte en tension, dans le sens où la valeur du paramètre de maille du réseau cristallin est supérieure à sa valeur normale lorsque le matériau est non contraint ou relaxé. La couche est contrainte en tension lorsqu'elle subit une contrainte mécanique qui tend à étirer les mailles du réseau cristallin dans le plan de la couche. Cela se traduit par la présence d'une contrainte en compression des mailles du réseau orientée suivant un axe sensiblement orthogonal au plan d'étirement, c'est-à-dire au plan de la couche.

Par collage direct, également appelé collage moléculaire ou collage par adhérence moléculaire, on entend la solidarisation de deux surfaces de matériaux identiques ou différents l'une contre l'autre sans apport de couche collante (de type colle, glue, etc...) mais par le biais des forces attractives d'interaction atomique ou moléculaire entre les surfaces à coller, par exemple des forces de Van der Walls, des liaisons hydrogène, voire des liaisons covalentes. La structure semiconductrice présente alors une énergie de collage qui, au premier ordre, peut s'écrire : $Ec \sim Es.S$, où $E_s$ est l'énergie surfacique de collage (on suppose ici que les surfaces à coller présentent des énergies de surface sensiblement égales) et S l'étendue des surfaces collées.

Comme il est détaillé par la suite, le collage moléculaire mis en oeuvre ici peut être de type hydrophile ou hydrophobe. Le collage est de type hydrophile lorsqu'il concerne l'adhérence de surfaces hydrophiles, c'est-à-dire de surfaces ayant la capacité à se lier avec des molécules d'eau par un mécanisme d'adsorption. Le collage met alors en jeu des forces de liaison hydrogène dont l'intensité d'interaction est particulièrement élevée. Pour cela, les surfaces

EP 3 151 265 B1

hydrophiles sont terminées par des groupements hydroxyles (-OH). Alternativement, le collage peut être de type hydrophobe et concerner alors des surfaces qui n'ont pas la capacité d'adsorber de l'eau. Pour cela, les surfaces hydrophobes peuvent être saturées d'atomes tels que l'hydrogène ou le fluor.

On décrit par la suite, à titre illustratif, un procédé de réalisation d'une structure semiconductrice, comportant une portion de germanium monocristallin contraint, collée par adhérence moléculaire à une couche support de silicium. Cependant, d'une manière générale, le matériau de la structure semiconductrice est monocristallin et peut être choisi parmi les éléments de la colonne IV de la classification périodique, tel que le silicium, le germanium, l'étain dans sa phase semiconductrice, et les alliages formés de ces éléments tels que le SiGe, le GeSn, le SiGeSn. Il peut également être choisi parmi les alliages comportant des éléments des colonnes III et V de la classification périodique. Par ailleurs, le matériau de la couche support peut être choisi parmi le silicium, le saphir, le borosilicate, la silice, le verre, le quartz ou tout autre matériau adapté à être collé par adhérence moléculaire au matériau de la structure semiconductrice. Enfin, le matériau de la couche sacrificielle peut être choisi parmi le silicium, un oxyde ou un nitrure, par exemple de silicium.

Les figures 1a à 1d sont des vues en coupe illustrant différentes étapes d'un procédé de réalisation d'une structure semiconductrice comportant une portion contrainte de germanium solidarisée par collage direct à une couche support en silicium, selon un premier mode de réalisation.

La figure 1a et les figures suivantes sont orientées suivant un repère orthonormé (X,Y,Z) où X et Y sont les axes horizontaux définissant un plan parallèle aux plans suivant lesquels s'étendent les différentes couches, et où Z est l'axe vertical suivant lequel l'épaisseur des couches est définie. Les termes « haut / bas », « inférieur / supérieur » sont définis suivant l'axe vertical Z.

Selon une première étape illustrée sur la figure 1a, on réalise un empilement formé d'une couche semiconductrice 10, comportant une partie structurée (non représentée), solidarisée à une couche support 30 par l'intermédiaire d'une couche sacrificielle 20.

Dans un premier temps, on réalise l'empilement sous forme d'un substrat GOI (pour *Germanium On Isulator,* en anglais), c'est-à-dire d'une couche semiconductrice 10 de germanium recouvrant une couche sacrificielle 20 d'oxyde de silicium reposant ici sur une couche support 30 de silicium. Cet empilement est de préférence réalisé au moyen du procédé décrit dans la publication de Reboud et al. intitulée Structural and optical properties of 200 mm germanium-on-insulator (GeOI) substrates for silicon photonics applications, Proc. SPIE 9367, Silicon Photonics X, 936714 (February 27, 2015) qui met notamment en oeuvre la technologie Smart Cut™.

Plus précisément, on effectue tout d'abord la croissance épitaxiale d'une couche semiconductrice de germanium cristallin sur une couche épaisse de silicium. La couche de germanium présente alors, à température ambiante, une déformation résiduelle en tension de l'ordre de 0,2%. On dépose ensuite une couche diélectrique, par exemple un oxyde de silicium, sur la surface libre de la couche de germanium, puis on effectue une implantation d'ions H$^+$ dans la couche de germanium. Ensuite, on solidarise la couche diélectrique recouvrant la couche de germanium avec un substrat poignée formée d'une couche diélectrique recouvrant une couche de silicium. On sépare la couche de germanium en deux parties au niveau d'une zone fragilisée par l'implantation d'ions. On obtient ainsi une couche semiconductrice 10 monocristalline de germanium recouvrant une couche sacrificielle 20, ici en oxyde de silicium, qui repose sur une couche support 30, par exemple une couche en silicium d'un substrat SOI. La surface libre de la couche de germanium peut ensuite être nettoyée par gravure ionique réactive (ou gravure RIE, pour *Reactive Ion Etching* en anglais) éventuellement suivie d'un polissage mécano-chimique (ou CMP, pour *Chemical Mechanical Polishing* en anglais).

De manière alternative, on peut réaliser l'empilement par croissance épitaxiale d'une couche de germanium sur un substrat, la couche de germanium étant ensuite recouverte d'une couche d'oxyde de silicium. On solidarise cet empilement par collage moléculaire avec un second empilement formé d'une couche de silicium recouverte d'une couche d'oxyde de silicium, le collage étant réalisé par mise en contact mutuel des couches d'oxydes de silicium. On supprime ensuite totalement le substrat, par exemple par meulage (*grinding,* en anglais), de manière à obtenir ainsi la couche semiconductrice de germanium liée à une couche support de silicium par une couche sacrificielle d'oxyde de silicium. Cette approche est notamment décrite dans la publication de Jan et al. intitulée Tensile-strained germanium-on-insulator substrate for silicon-compatible optoelectronics, Opt. Mater. Express 1, 1121-1126 (2011).

La couche semiconductrice de germanium peut présenter, selon les applications électroniques ou optoélectroniques visées, une épaisseur de l'ordre de quelques dizaines de nanomètres à quelques microns. La couche sacrificielle peut présenter une épaisseur de l'ordre de quelques dizaines de nanomètres à quelques microns. La couche support peut présenter une épaisseur de quelques dizaines de nanomètres à quelques microns.

La réalisation de la couche semiconductrice 10 d'épaisseur voulue au moyen du procédé décrit dans la publication de Reboud et al. 2015 est particulièrement avantageuse dans la mesure où la qualité cristalline de la couche semiconductrice 10 est particulièrement élevée et sensiblement homogène suivant l'épaisseur de la couche. A titre d'exemple, la densité de dislocations peut être inférieure à 10$^7$ cm$^{-2}$ sur toute l'épaisseur de la couche, en particulier au niveau de l'interface avec la couche sacrificielle 20.

La couche semiconductrice 10 présente une contrainte en tension non nulle, c'est-à-dire que la contrainte de la couche semiconductrice, dans le plan XY de la couche, présente une valeur initiale $\sigma_{pc}^i$ non nulle et positive. Ici, la valeur initiale $\sigma_{pc}^i$ de contrainte de la couche semiconductrice 10 peut ne pas être suffisante pour que la structure de bandes soit directe, autrement dit $\Delta E < 0$.

Dans un second temps, on structure la couche semiconductrice 10 de manière à ce qu'elle présente une partie structurée 11 entourée d'une partie périphérique 12, la partie structurée 11 comportant une portion centrale 40 et des portions latérales 50 qui relient cette dernière à la partie périphérique 12 (cf. par exemple fig.1b, 2a ou 3a). La partie structurée 11 est réalisée par des étapes classiques de lithographie optique et/ou électronique puis de gravure de la couche semiconductrice 10, qui ne sont donc pas détaillées ici.

Comme illustrées sur la figure 2a ou 3a qui illustrent des exemples de motifs formés par la partie structurée 11 de la couche semiconductrice 10, la portion centrale 40 peut présenter une forme, dans le plan (X,Y), sensiblement carrée ou rectangulaire, de quelques centaines de nanomètres à quelques microns de côté. D'autres formes sont possibles, telles que des formes allongées voire polygonales.

Au moins deux portions latérales 50 sont réalisées qui relient chacune une bordure de la portion centrale 40 à la partie périphérique 12. Elles sont agencées deux à deux vis-à-vis de la portion centrale 40 de manière à définir au moins un axe de déformation sensiblement rectiligne. Dans l'exemple de la figure 2a, deux paires de portions latérales 50 sont représentées où ces dernières s'étendent chacune à partie d'une bordure de la portion centrale 40 de forme sensiblement carrée jusqu'à la partie périphérique 12. Les portions latérales 50 sont agencées deux à deux de manière à définir ici ainsi deux axes de déformation sécants l'un avec l'autre au niveau de la portion centrale 40. Ainsi, une déformation biaxiale de la portion centrale 40, orientée suivant les deux axes de déformation, est en mesure d'être générée lorsque la partie structurée 11 sera suspendue lors d'une étape ultérieure. Dans l'exemple de la figure 3a, une unique paire de portions latérales 50 est représentée où ces dernières sont agencées de manière à définir un unique axe de déformation de la portion centrale 40. Ainsi, une déformation uniaxiale est en mesure d'être générée dans la portion centrale 40 lors d'une étape ultérieure.

La portion centrale 40 est destinée à devenir une portion contrainte en tension présentant une déformation de son réseau cristallin, c'est-à-dire ici une augmentation de son paramètre de maille, générée par les portions latérales 50. Les portions latérales 50 sont ainsi destinées à mettre en tension la portion centrale 40, de préférence sans pour autant subir elles-mêmes une contrainte mécanique propre, hormis la contrainte résiduelle mentionnée précédemment. Pour cela, on forme les portions latérales 50, ou bras tenseurs, et la portion centrale 40 pour que la largeur moyenne « b » des bras tenseurs 50 soit supérieure à la largeur moyenne « a » de la portion centrale 40, de préférence dix fois supérieure à cette dernière. Par largeur, on entend la dimension transversale d'une portion ou d'un bras, dans le plan (X,Y), à son axe longitudinal. La portion centrale 40 présente ici une largeur moyenne « a » orientée suivant l'axe Y et sensiblement constante suivant l'axe longitudinal X. Les bras tenseurs 50 présentent une largeur moyenne « b » orientée ici suivant l'axe Y. En outre, la dimension surfacique dans le plan (X,Y), et en particulier la largeur de chaque portion latérale 50, c'est-à-dire la dimension transversale sensiblement orthogonale à l'axe de déformation, est choisie de sorte que la portion latérale 50 ne présente sensiblement pas ou peu de déformation. Plus précisément, la déformation moyenne, dans l'épaisseur de la portion latérale 50, diminue à mesure qu'on s'éloigne de la portion centrale 40 et devient négligeable à une distance supérieure ou égale à une ou deux fois la dimension de la portion centrale 40. La largeur moyenne de chaque portion latérale est supérieure à la largeur moyenne de la portion centrale, de préférence dix fois supérieure à cette dernière. La déformation moyenne de la portion latérale 50, c'est-à-dire le champ de déformation intégré dans le volume de la portion latérale présente une valeur inférieure à celle de la portion contrainte, voire est négligeable vis-à-vis de la déformation moyenne dans la portion contrainte. Sur les exemples des figures 2a et 3a, les portions latérales 50 présentent une forme de trapèze de sorte que la largeur augmente à mesure que l'on s'éloigne de la portion centrale 40. D'autres formes sont possibles, par exemple une forme similaire ou identique à celle représentée dans l'article de Sukhdeo et al. 2014 mentionné précédemment, où les portions latérales présentent une augmentation brusque de largeur vis-à-vis de la portion centrale puis une zone principale à largeur constante.

La structuration peut être réalisée de manière à contrôler la valeur de l'amplification de la contrainte en tension de la portion centrale 40 de la couche semiconductrice 10, obtenue ultérieurement lors de la réalisation de la cavité. Pour cela, on prédétermine les paramètres dimensionnels de la partie structurée 11, par exemple les largeurs et longueurs de la portion centrale 40 et des bras tenseurs 50. A titre d'exemple, dans le cas d'une portion centrale 40 rectangulaire, de longueur A et de largeur constante a, et des bras tenseurs 50 rectangulaires de longueur B/2-A/2 et de largeur constante b, un facteur d'amplification f reliant la contrainte finale en tension $\sigma_{pc}^f$ à la contrainte initiale en tension $\sigma_{pc}^i$ peut s'exprimer par la relation suivante formulée dans l'article de Süess et al intitulé Analysis of enhanced light emission from highly strained germanium microbridges, Nature Photon. 7, 466-472 (2013) :

$$f = \frac{2L+B}{B}\left(1 + \frac{A}{B-A}\right)/\left(\frac{a}{b} + \frac{A}{B-A}\right)$$

où L est la longueur de la couche sacrificielle 20 supprimée sous la partie structurée 11 lors de l'étape ultérieure de réalisation de la cavité. Ainsi, en fonction des paramètres dimensionnels de la partie structurée 11 de la couche semiconductrice 10, on est en mesure de contrôler la valeur de l'amplification de la contrainte en tension appliquée à la portion centrale 40 lors de la réalisation de la cavité. Le facteur d'amplification peut également être estimé au moyen d'un logiciel de simulation numérique tel que COMSOL Multiphysics.

Ainsi, on obtient une couche semiconductrice 10 structurée localement recouvrant la couche sacrificielle 20. La couche semiconductrice 10 présente une partie structurée 11 comportant une portion centrale 40 ici reliée par des portions latérales 50 à une partie périphérique 12 de la couche 10. La portion centrale 40 est destinée à subir une contrainte en tension issue d'une déformation générée par les portions latérales 50.

Selon une deuxième étape illustrée sur les figures 1b et 1c, on réalise une cavité sous la partie structurée de la couche semiconductrice de manière à la suspendre au-dessus d'une surface rendue libre de la couche support. Puis, on effectue la mise en contact de la partie structurée suspendue avec la surface libre de la couche support.

Dans un premier temps, comme illustré sur la figure 1b, la cavité 21 est réalisée par gravure humide de la couche sacrificielle 20 rendue accessible par des ouvertures obtenues lors de la structuration de la couche semiconductrice 10. La gravure humide utilise ici de l'acide fluorhydrique (également appelé HF, pour *Hydrogen Fluoride* en anglais) en phase vapeur. Le flux de vapeur HF peut être faible de manière à graver la couche sacrificielle à une vitesse modérée de l'ordre de 10nm par minute. Plus précisément, le flux de vapeur peut, à titre d'exemple, comporter de l'acide fluorhydrique à 15 torr de pression partielle, de l'alcool à 0,01 torr et de l'azote à 60 torr. Ainsi, on grave sur toute son épaisseur la partie de la couche sacrificielle 20 située sous la partie structurée 11 de la couche semiconductrice 10. La partie structurée 11 est alors suspendue au-dessus de la surface rendue libre 31 de la couche support 30, formant ainsi une cavité 21. La cavité 21 est donc située entre la partie structurée 11 et la surface libre 31 de la couche support 30.

On obtient ainsi une partie structurée 11 suspendue, qui prend la forme d'une membrane suspendue, dont les portions latérales 50 forment maintenant des bras tenseurs qui maintiennent la portion centrale 40 au-dessus de la surface libre 31 de la couche support 30 et génèrent dans la portion centrale 40 une contrainte mécanique en tension orientée suivant les axes de déformation. La surface inférieure 13 de la partie structurée 11 et la surface libre 31 de la couche support 30 présentent ici une rugosité inférieure ou égale à 10nm RMS environ, propice au collage moléculaire effectué lors d'une étape ultérieure. Les dimensions respectives de la portion centrale 40 et des portions latérales 50 sont telles que les bras tenseurs génèrent une contrainte en tension dans la portion contrainte sensiblement égale à une valeur prédéterminée de déformation. Dans cet exemple, la déformation de la portion contrainte 40 en germanium est telle que la structure de bandes d'énergie du germanium devient directe. Dans la suite de la description, la portion centrale 40 est appelée portion contrainte et les portions latérales 50 sont appelées bras tenseurs.

Dans un second temps, comme illustré sur la figure 1c, on réalise la mise en contact de la membrane suspendue 11, plus précisément de la portion contrainte 40 et d'au moins une partie des bras tenseurs 50, avec la surface libre 31 de la couche support. Pour cela, on immerge la partie structurée 11 dans une solution liquide, par exemple d'alcool ou d'eau déionisée acidifiée (pH proche de 2), puis on évapore le liquide. Lors de la phase d'évaporation, la partie structurée 11 suspendue vient naturellement au contact de la surface libre 31 de la couche support. Ainsi, la partie structurée 11 repose sur la couche support, de sorte que la surface inférieure d'au moins une partie des bras tenseurs 50 est au contact avec la surface libre 31 de la couche support. La surface inférieure de la portion contrainte 40 peut être totalement, partiellement, ou pas au contact de la surface libre 31.

La mise en contact de ces surfaces assure un collage direct, ici de type hydrophobe, de la partie structurée 11 avec la couche support 30. Le collage direct est ici de type hydrophobe dans la mesure où les surfaces se solidarisent l'une à l'autre par l'intermédiaire de liaisons hydrogène. A température ambiante, comme l'illustre la figure 4 représentant l'évolution de l'énergie surfacique de collage hydrophobe entre les surfaces collées, l'énergie de collage hydrophobe est ici de l'ordre de 5mJ/m$^2$.

Par mise en contact, on entend le contact de la surface inférieure 13 de la partie structurée avec la surface rendue libre 31 de la couche support. Ces surfaces peuvent être formées du matériau composant principalement les couches ou d'un matériau intercalaire différent de ce matériau principal. La couche semiconductrice et la couche support peuvent ainsi comporter une couche mince d'un matériau intercalaire obtenu par exemple par dépôt ou par oxydation, de préférence après formation de la cavité. Dans le procédé décrit ici faisant intervenir le collage hydrophobe, la couche semiconductrice et la couche support ne comporte pas de matériau intercalaire.

Ainsi, on obtient une partie structurée 11 de la couche semiconductrice 10, collée sur la surface libre 31 de la couche support 30. La partie structurée 11 collée comporte la portion contrainte 40 et une partie des bras tenseurs 50. La partie non collée des bras tenseurs 50 est située dans la zone où ceux-ci rejoignent la partie périphérique 12 de la couche semiconductrice 10, cette dernière reposant sur la partie non gravée de la couche sacrificielle 20.

En variante, l'étape de de réalisation de la cavité 21 et de mise en contact de la partie structurée 11 avec la surface libre 31 de la couche support peut être réalisée dans le même temps. Pour cela, la cavité 21 est par exemple réalisée par gravure humide par HF liquide voire par HF vapeur en haute pression. Dans le cas d'une gravure par HF vapeur, le flux de vapeur peut comporter de l'acide fluorhydrique à 60 torr de pression partielle, de l'alcool à 0,1 torr et de l'azote à 75 torr. Le flux de gaz conduit alors à une vitesse de gravure plus importante que celle mentionnée précédemment, par exemple de l'ordre de 100nm/min, lors d'une réaction de gravure hors-équilibre. Aussi, des gouttes d'eau et d'acide fluorhydrique, produits de la réaction chimique, se forment dans la cavité et provoquent, en évaporant, la mise en contact de la partie structurée avec la surface libre de la couche support.

A l'issue de cette étape, la partie structurée 11 collée, formée de la portion contrainte 40 et des bras tenseurs 50 reposant sur la couche support 30, présente :

○ une énergie de collage Ec, issue du collage moléculaire hydrophobe sur la couche support. Elle peut être estimée, au premier ordre, par la relation :

$$E_c \approx E_s\left(S_{bt} + S_{pc}\right)$$

où Es est l'énergie de surface évaluée à partir de la relation illustrée sur la figure 4, et $S_{bt}$ et $S_{pc}$ sont les surfaces respectives des bras tenseurs et de la portion contrainte. L'énergie de collage tend à stabiliser la partie structurée collée et à éviter toute relaxation des contraintes susceptibles de modifier sa tenue mécanique ainsi que sa structure cristallographique, et donc de dégrader ses propriétés électriques et/ou optiques ;
○ une énergie élastique Ee, issue de la contrainte mécanique en tension liée à la déformation de la portion contrainte par les bras tenseurs. Elle peut être estimée, au premier ordre, par la relation :

$$E_e \approx eE\left(\bar{\varepsilon}_{bt}^2 S_{bt} + \bar{\varepsilon}_{pc}^2 S_{pc}\right)$$

où e est l'épaisseur moyenne de la portion contrainte et des bras tenseurs, E le module d'Young et $\overline{\varepsilon_{bt}}$ la valeur moyenne de déformation subie par les bras tenseurs et $\overline{\varepsilon_{pc}}$ la valeur moyenne de la déformation subie par la portion contrainte. L'énergie élastique tend à déstabiliser la partie contrainte collée de manière à relaxer naturellement les contraintes.

On peut noter que, au premier ordre, l'énergie de collage comporte un terme prépondérant lié à la surface collée des bras tenseurs, celle-ci est généralement supérieure à la surface collée de la portion contrainte. Par ailleurs, l'énergie élastique comporte un terme prépondérant lié à la déformation de la portion contrainte, dans la mesure où les bras tenseurs présentent une valeur moyenne de déformation proche de la valeur de déformation résiduelle, celle-ci étant inférieure à la valeur de la déformation subie par la portion contrainte.

Dans le but de réaliser une structure semiconductrice à portion contrainte, dont la tenue mécanique et donc les propriétés électriques et/ou optiques sont préservées, qui puisse être séparée de la partie périphérique 12 de la couche semiconductrice 10, l'énergie de collage doit être supérieure à l'énergie élastique, ce qui se traduit au premier ordre par l'inégalité suivante :

$$E_s^{min}\left(S_{bt}^{min} + S_{pc}\right) > eE\left(\bar{\varepsilon}_{bt}^2 S_{bt}^{min} + \bar{\varepsilon}_{pc}^2 S_{pc}\right)$$

Pour cela, selon l'invention, on détermine à la fois la valeur minimale d'énergie surfacique de collage $E_s^{min}$ et la valeur minimale de surface collée $S_{bt}^{min}$ des bras tenseurs, nécessaires pour vérifier cette inégalité. Bien entendu, cette inégalité peut être précisée en utilisant des expressions de l'énergie de collage et de l'énergie élastique plus détaillées, par exemple en intégrant le champ de contrainte dans tout le volume de la partie structurée collée.

Ainsi, à titre illustratif, pour une portion contrainte 40 de germanium de surface $S_{pc}$ de $5\mu m^2$ présentant une déformation moyenne uniaxiale de 5,7%, d'épaisseur e de 300nm, le module Young étant égal à 50GPa environ, et les bras tenseurs 50 présentant une déformation moyenne proche de la valeur résiduelle de 0,2%, et enfin pour une énergie surfacique de collage $E_s$ de $100mJ/m^2$, il ressort que la surface collée minimale $S_{bt}$ des bras tenseurs est égale à environ $6550\mu m^2$. On remarque qu'en appliquant un traitement thermique à 600°C pendant quelques minutes à quelques heures, l'énergie surfacique de collage hydrophobe $E_s$ passe à $1J/m^2$, ce qui permet alors d'obtenir une surface collée minimale $S_{bt}^{min}$ des bras tenseurs d'environ $290\mu m^2$. De préférence, chacun des deux bras tenseurs présente alors une surface collée minimale $S_{bt}^{min}$ de $145\mu m^2$.

Selon une troisième étape, on effectue un renforcement du collage moléculaire de la partie structurée 11 solidaire de la surface libre 31 de la couche support, de manière à obtenir une valeur Es d'énergie surfacique de collage supérieure ou égale à la valeur minimale $E_s^{min}$ déterminée préalablement.

Pour cela, on réalise un traitement thermique, sous forme d'un recuit de consolidation, dans lequel on soumet l'empilement à une température de recuit Tr pendant quelques minutes à quelques heures. A titre illustratif, la température de recuit peut être de 200°C appliquée pendant 2h, ce qui augmente ici l'énergie surfacique de collage hydrophobe de 5mJ/m² à 100mJ/m².

La température de recuit est comprise entre une valeur minimale qui dépend notamment de la surface minimale collée $S_{bt}^{min}$ de bras tenseurs que l'on souhaite conserver et une valeur maximale qui dépend notamment de la qualité cristallographique à préserver de la couche semiconductrice. La valeur maximale de la température de recuit peut ainsi être inférieure à la température de croissance épitaxiale de la couche semiconductrice.

Ainsi, on obtient une partie structurée 11 collée à la couche support 30 avec une énergie de collage Ec dont la valeur est supérieure ou égale à la valeur minimale prédéterminée. On est alors en mesure de supprimer une partie des bras tenseurs 50 pour séparer la partie structurée 11 de la partie périphérique 12.

Dans une quatrième étape illustrée sur les figures 1d, on retire, par gravure, une portion distale 51 des bras tenseurs 50 de manière à séparer, ou individualiser, la partie structurée 11 vis-à-vis de la partie périphérique 12 de la couche semiconductrice 10.

Par séparer, rendre distincte ou individualiser, on entend ici que la partie structurée 11 n'est plus reliée à la partie périphérique 12 par les bras tenseurs 50. De plus, par portion distale 51 des bras tenseurs, on entend la zone des bras tenseurs 50 éloignée de la portion contrainte 40 et formant le raccord avec la partie périphérique 12 de la couche semiconductrice.

On supprime, par des opérations classiques de lithographie optique et/ou électronique et de gravure, la portion distale 51 des bras tenseurs de manière à ce que la partie structurée 11 collée comporte une valeur de surface collée $S_{bt}$ des bras tenseurs supérieure ou égale à la valeur minimale $S_{bt}^{min}$ déterminée préalablement. Ainsi, la surface collée des bras tenseurs 50 est suffisante pour que la partie structurée 11 collée présente une énergie de collage supérieure à son énergie élastique.

Ainsi, on obtient une structure semiconductrice 1 à portion contrainte 40 collée sur la couche support 30 dont la tenue mécanique est assurée, préservant ainsi ses propriétés électriques et/ou optiques. La structure semiconductrice 1 présente une qualité cristalline élevée et la portion contrainte 40 une déformation moyenne prédéterminée. Elle est solidarisée de la couche support 30 par collage moléculaire dont l'énergie de collage et la surface collée des bras tenseurs 50 permettent de figer le champ de contrainte.

La figure 11 illustre un organigramme d'un procédé selon un mode de réalisation, permettant d'obtenir une portion centrale 40 de la couche semiconductrice 10 à structure de bandes directe.

Lors d'une première étape 110, on estime, pour la couche semiconductrice 10, la valeur minimale $\sigma_{pc}^{f,min}$ de contrainte en tension permettant d'obtenir une structure de bandes directe, autrement dit $\Delta E = E_{min,L} - E_{min,\Gamma} \geq 0$. La valeur minimale $\sigma_{pc}^{f,min}$ de contrainte en tension peut être estimée à partir de l'article de Sukhdeo et al. intitulé Direct bandgap germanium-on-silicon inferred from 5,7% <100> uniaxial tensile strain, Photon. Res. Vol. 2, No. 3, A8, 2014 qui illustre un exemple d'évolution de $\Delta E$ en fonction de la valeur de la contrainte en tension de la couche semiconductrice 10.

Lors d'une deuxième étape 120, on fournit l'empilement dans lequel la couche semiconductrice 10 présente alors une contrainte en tension dans le plan (X,Y) de valeur initiale $\sigma_{pc}^{i}$ non nulle et positive, mais inférieure à $\sigma_{pc}^{f,min}$. La couche semiconductrice 10 présente alors une structure de bandes indirecte $\Delta E < 0$.

Lors d'une troisième étape 130, on détermine puis on réalise une structuration de la couche semiconductrice 10 de manière à former la partie structurée 11 décrite précédemment. La structuration est déterminée de sorte que la formation de la cavité sous-jacente de la partie structurée 11 provoque l'augmentation de la contrainte en tension de la portion centrale 40, qui passe alors de la valeur initiale $\sigma_{pc}^{i}$ à la valeur finale $\sigma_{pc}^{f}$, celle-ci étant alors supérieure ou égale à $\sigma_{pc}^{f,min}$. Pour cela, on note F la fonction de transfert permettant de passer de $\sigma_{pc}^{i}$ à $\sigma_{pc}^{f}$, autrement dit : $\sigma_{pc}^{f} = F(\sigma_{pc}^{i})$. La fonction de transfert F est paramétrée essentiellement par les dimensions de la partie structurée 11, et notamment par la largeur moyenne des bras tenseurs 50 et celle de la portion centrale 40. La fonction de transfert peut être identique ou similaire au facteur d'amplification f mentionné précédemment. On détermine donc les paramètres de la fonction de transfert F, par exemple par simulation numérique à l'aide du logiciel COMSOL Multiphysics ou en vérifiant la relation mentionnée précédemment.

Lors d'une quatrième étape 140, on forme la cavité sous la partie structurée 11 par gravure partielle de la couche sacrificielle 20. Ainsi, la portion centrale 40 passe de la valeur initiale $\sigma_{pc}^{i}$ à la valeur finale $\sigma_{pc}^{f} = F(\sigma_{pc}^{i})$ de contrainte dans le plan (X,Y), la valeur finale $\sigma_{pc}^{f}$ étant alors supérieure ou égale à $\sigma_{pc}^{f,min}$. On obtient ainsi une couche centrale 40 qui présente une structure de bandes directe $\Delta E \geq 0$.

Les figures 2a et 2b illustrent deux étapes du procédé décrit précédemment correspondant respectivement aux figures 1c et 1d. Sur la figure 2a est illustrée la partie structurée 11 collée par adhérence moléculaire à la surface rendue libre 31 de la couche support 30. La portion contrainte 40 est reliée à la partie périphérique 12 de la couche semiconductrice par l'intermédiaire des bras tenseurs 50. Deux paires de bras tenseurs 50 de dimensions identiques sont représentées, ce qui induit une déformation biaxiale de la portion contrainte 40, d'intensité sensiblement égale selon les deux axes de déformation ici respectivement parallèles aux axes X et Y. En variante, chaque paire de bras tenseurs peut présenter des dimensions différentes, de manière à déformer la portion contrainte avec une intensité différente suivant chacun des axes de déformation. Sur la figure 2b est illustrée la structure semiconductrice 1 à portion contrainte 40, obtenue en séparant la partie structurée 11 de la partie périphérique 12 de la couche semiconductrice 10, par gravure de la zone distale des bras tenseurs 50 faisant raccord avec la partie périphérique 12.

Les figures 3a et 3b sont similaires aux figures 2a et 2b et s'en distinguent essentiellement en ce que la partie structurée 11 comporte une unique paire de bras tenseurs 50 assurant la mise en tension uniaxiale de la portion contrainte 40. Cette dernière subit alors une déformation uniaxiale suivant l'axe de déformation définie par l'agencement des bras tenseurs 50 vis-à-vis de la portion contrainte 40. La figure 3a illustre la partie structurée 11 collée par adhérence moléculaire à la surface rendue libre 31 de la couche support 30, où les bras tenseurs 50 relient la portion contrainte 40 à la partie périphérique 12 de la couche semiconductrice. La figure 3b illustre la structure semiconductrice 1 obtenue à partir de la partie structurée 11 collée en gravant la zone de raccord des bras tenseurs 50 à la partie périphérique (celle-ci étant également supprimée).

La figure 4 illustre un exemple de relation entre l'énergie surfacique de collage entre une surface de germanium et une surface de silicium en fonction de la température de recuit, dans le cas d'un collage de type hydrophile et d'un collage de type hydrophobe. Jusqu'à 600°C environ, l'énergie surfacique de collage présente une valeur inférieure dans le cas hydrophobe que dans le cas hydrophile. La tendance s'inverse ensuite à partir de 600°C environ. Par ailleurs, dans le cas hydrophile, l'énergie surfacique augmente dès qu'un recuit à 100°C environ est appliqué, et l'on passe d'une énergie de l'ordre de 100mJ/m$^2$ à température ambiante à 1J/m$^2$ après un recuit à 200°C environ. Dans le cas hydrophobe, on passe d'une énergie de l'ordre de 5mJ/m$^2$ à température ambiante à 100mJ/m$^2$ après un recuit à 200°C environ.

Les figures 5a à 5e illustrent un procédé de réalisation de la structure semiconductrice à portion contrainte selon un second mode de réalisation. Ce procédé se distingue du premier mode de réalisation essentiellement en ce que le collage moléculaire est de type hydrophile.

La figure 5a illustre la fourniture d'un empilement formé d'une couche semiconductrice 10 solidaire d'une couche support 30 par une couche sacrificielle 20, puis la structuration de la couche semiconductrice 10 de manière à former une partie structurée 11 et une partie périphérique 12, la partie structurée 11 comportant une portion centrale 40 reliée à la partie périphérique 12 par le biais d'au moins une paire de portions latérales 50 (cf. par exemple fig. 5b, 2a ou 3a). Ces étapes sont identiques à celles décrites en référence aux figures 1a et 2a ou 3a, et ne sont pas détaillées ici davantage.

La figure 5b illustre la réalisation d'une cavité 21 située sous la partie structurée 11, de manière à suspendre la partie structurée 11 au-dessus d'une surface rendue libre 31 de la couche support 30. Comme mentionné précédemment, la cavité 21 peut être réalisée par gravure humide de la couche sacrificielle 20 rendue accessible par des ouvertures obtenues lors de la structuration de la couche semiconductrice 10. La gravure humide utilise ici de l'acide fluorhydrique HF en phase vapeur. Le flux de vapeur HF peut être faible de manière à graver la couche sacrificielle à une vitesse modérée de l'ordre de 10nm par minute. Plus précisément, le flux de vapeur peut, à titre d'exemple, comporter de l'acide fluorhydrique à 15 torr de pression partielle, de l'alcool à 0,01 torr et de l'azote à 60 torr. Ainsi, on grave sur toute son épaisseur la partie de la couche sacrificielle 20 située sous la partie structurée 11. La partie structurée 11 est alors suspendue au-dessus de la surface rendue libre 31 de la couche support, formant ainsi une cavité 21.

En variante, la surface 31 de la couche support peut être formée d'une couche supérieure (non représentée) en un oxyde thermique, c'est-à-dire obtenu par oxydation thermique. La vitesse de gravure humide HF de la couche sacrificielle 20, lorsque celle-ci est réalisée en un oxyde déposé, est supérieure à celle de la couche supérieure d'oxyde thermique. Ainsi, lors de l'étape de réalisation de la cavité 21, la couche sacrificielle est supprimée au niveau de la partie structurée 11 et la face supérieure 31 de la couche d'oxyde thermique est alors rendue libre. On est ainsi en mesure de contrôler l'épaisseur de la couche d'oxyde séparant la structure semiconductrice 1 vis-à-vis de la couche support 30. En variante, la couche sacrificielle peut comporter une sous-couche d'oxyde déposé, au contact de la couche semiconductrice 10 de germanium, et une sous-couche d'oxyde thermique sous-jacente, située entre la sous-couche d'oxyde déposé et la couche support 30 de silicium, les sous-couches étant avantageusement séparées par une couche mince d'arrêt de gravure.

La figure 5c illustre une étape de traitement de surface de la partie structurée 11 et de la surface libre 31 de la couche support, dans le but d'assurer ultérieurement le collage moléculaire hydrophile de ces éléments. Lors de cette étape, on traite la surface 13 de la partie structurée 11 en regard de la cavité 21 et la surface libre 31 de la couche support de sorte qu'elles soient formées chacune d'une couche mince 14, 15 d'oxyde ou de nitrure, d'une épaisseur de quelques nanomètres à quelques dizaines de nanomètres.

Selon une variante, la partie structurée 11 et la couche support 30 sont recouvertes, au niveau de la cavité 21, d'une couche mince d'oxyde 14, 15 réalisée par oxydation. Les couches minces d'oxyde 14, 15 peuvent être obtenues par mise à l'air libre de cette zone de l'empilement pendant une durée suffisante, par exemple 1h. Elles peuvent également être obtenues par une technique d'oxydation par plasma $O_3$, par exemple à température ambiante, voire par une technique d'oxydation par plasma $O_2$, par exemple à une température de 250°C. Dans le cadre de l'exemple préféré, la partie structurée en germanium monocristallin présente une surface inférieure 13 formée d'une couche mince d'oxyde de germanium 14 d'une épaisseur de l'ordre de quelques nanomètres à quelques dizaines de nanomètres, et la surface libre 31 de la couche support en silicium est formée d'une couche mince d'oxyde de silicium 15 d'une épaisseur également de l'ordre de quelques nanomètres à quelques dizaines de nanomètres.

Selon une autre variante, la partie structurée 11 et la couche support 30 sont recouvertes, au niveau de la cavité 21, d'une couche mince d'oxyde ou de nitrure obtenue par une technique de dépôt de couche mince. Les couches sont, par exemple, déposées par une technique du type ALD (pour *Atomic Layer Deposition,* en anglais) assisté ou non par plasma. Le matériau déposé peut être un oxyde ou un nitrure de silicium, $SiO_2$ ou $Si_3N_4$, voire être un oxyde d'hafnium $HfO_2$, de titane $TiO_2$, voire d'aluminium $Al_2O_3$, ou tout autre matériau adapté. Ainsi, dans le cadre de l'exemple préféré, la partie structurée 11 en germanium monocristallin présente une surface inférieure 13 formée d'une couche mince, par exemple, d'oxyde de silicium d'une épaisseur de l'ordre de quelques dizaines de nanomètres, et la surface libre 31 de la couche support 30 en silicium est formée d'une couche mince d'oxyde de silicium d'une épaisseur également de l'ordre de quelques dizaines de nanomètres.

Comme décrit précédemment, on obtient ainsi une partie structurée 11 suspendue, qui prend la forme d'une membrane suspendue, dont les portions latérales 50 forment des bras tenseurs qui maintiennent la portion centrale 40 au-dessus de la surface libre 31 de la couche support et génèrent dans la portion centrale 40 une contrainte mécanique en tension orientée suivant les axes de déformation. La surface inférieure 13 de la partie structurée et la surface libre 31 de la couche support présentent ici une rugosité inférieure ou égale à 10nm RMS environ, propice au collage moléculaire effectué lors d'une étape ultérieure.

La figure 5d illustre l'étape de mise en contact de la partie structurée 11 avec la surface libre 31 de la couche support. Pour cela, on immerge la partie structurée suspendue 11 dans une solution liquide, par exemple d'alcool ou d'eau déionizée acidifiée (pH proche de 2), puis on procède à l'évaporation du liquide. De préférence, on immerge la partie structurée 11 dans une solution liquide d'azote (par exemple à une température de 70K environ) ou d'hélium (par exemple à une température de 4K environ), puis on procède à l'évaporation du liquide. Lors de la phase d'immersion ou d'évaporation, la membrane suspendue 11 vient naturellement au contact de la surface libre 31 de la couche support. L'utilisation d'hélium ou d'azote (ou de tout autre liquide adéquat), donc associée à une diminution de la température préalablement à la mise en contact de la partie structurée 11 sur la couche support 30, permet de générer une mise en tension plus importante de la partie structurée 11. Ainsi, la partie structurée 11 repose sur la couche support 30, de sorte que la surface inférieure d'au moins une partie des bras tenseurs 50 est au contact avec la surface libre 31 de la couche support. La surface inférieure de la portion contrainte 40 peut être au contact totalement, partiellement, voire n'être pas au contact avec la surface libre 31.

La mise en contact de ces surfaces assure un collage direct de type hydrophile de la partie semiconductrice structurée sur la couche support. A température ambiante, comme l'illustre la figure 4, l'énergie de collage hydrophile est ici de l'ordre de 100mJ/m$^2$.

La mise en contact correspond ici au contact de la surface inférieure 13 de la partie structurée avec la surface libre 31 de la couche support, ces surfaces étant formées de la couche mince 14, 15 obtenue par oxydation ou par dépôt. Ainsi, une couche 14, 15 d'un matériau intercalaire est présente entre le matériau composant principalement la partie structurée 11 et le matériau composant principalement la couche support 30. Cette couche dite intercalaire 14, 15 présente une épaisseur de l'ordre de quelques dizaines de nanomètres à une ou plusieurs centaines de nanomètres. Elle est avantageusement diélectrique et peut ainsi assurer l'isolation électrique de la portion contrainte vis-à-vis de la couche support.

On effectue ensuite une étape de détermination de la valeur minimale d'énergie surfacique de collage $E_s^{min}$, ici hydrophile, et la valeur minimale de surface collée $S_{bt}^{min}$ des bras tenseurs, nécessaires pour que l'énergie de collage hydrophile de la partie structurée soit supérieure à l'énergie élastique de cette même partie structurée.

Ainsi, à titre illustratif, pour une portion contrainte de germanium de surface $S_{pc}$ de 5µm$^2$ présentant une

déformation moyenne uniaxiale de 5,7%, d'épaisseur e de 300nm, le module Young étant égal à 100GPa environ, et les bras tenseurs présentant une déformation moyenne proche de la valeur résiduelle de 0,2%, et enfin pour une énergie surfacique de collage hydrophile $E_s$ de 1J/m$^2$, la surface collée minimale $S_{bt}^{min}$ des bras tenseurs est d'environ 290$\mu$m$^2$.

On effectue ensuite une étape de renforcement du collage moléculaire de la partie structurée 11 solidarisée de la surface libre 31 de la couche support, de manière à obtenir une valeur Es d'énergie surfacique de collage hydrophile supérieure ou égale à la valeur minimale $E_s^{min}$ déterminée préalablement. Pour cela, on réalise un traitement thermique, sous forme d'un recuit de consolidation, dans lequel on soumet l'empilement à une température de recuit Tr pendant quelques minutes à quelques heures. A titre illustratif, la température de recuit peut être de 200°C appliquée pendant 2h, ce qui augmente ici l'énergie surfacique de collage hydrophile de 100mJ/m$^2$ à 1J/m$^2$.

En référence à la figure 5e, on retire, par gravure, une portion distale des bras tenseurs de manière à individualiser la partie structurée vis-à-vis de la partie périphérique de la couche semiconductrice. Cette étape est similaire à l'étape décrite précédemment en référence à la figure 1d et n'est pas détaillée davantage ici.

Ainsi, on obtient une structure semiconductrice 1 à portion contrainte 40 collée par adhérence moléculaire hydrophile sur la couche support 30, dont la tenue mécanique est assurée et les propriétés électriques et/ou optiques préservées. Le procédé selon le second mode de réalisation se distingue donc du premier mode de réalisation essentiellement par le collage hydrophile, dont l'intensité est supérieure à celle du collage hydrophobe jusqu'à des températures de recuit de l'ordre de 500°C à 600°C, et par la présence d'une couche 14, 15 d'un oxyde ou nitrure intercalaire à l'interface entre la partie structurée 11 et la couche support 30, dont la propriété diélectrique assure une isolation électrique entre ces éléments. Ce matériau intercalaire, outre une fonction d'isolation électrique, peut également assurer une fonction d'évacuation de la chaleur éventuellement produite au niveau de la portion contrainte, dans le cas où cette dernière forme une couche émissive d'une source lumineuse.

La portion contrainte 40 de la structure semiconductrice 1 peut être formée d'un matériau intrinsèque (non intentionnellement dopé) ou dopé de manière intentionnelle, selon les applications électroniques et/ou optiques voulues et l'intensité de déformation désirée. A titre illustratif, pour obtenir une portion contrainte 40 en germanium monocristallin non intentionnellement dopé présentant une structure de bandes d'énergie sensiblement directe, la déformation requise est de l'ordre de 5,6% dans le cas d'une déformation uniaxiale et de l'ordre de 2,0% dans le cas d'une déformation biaxiale. L'intensité de la déformation est diminuée dans le cas où le germanium est dopé. Ainsi, pour un niveau de dopage de 2.10$^{18}$cm$^{-3}$, la déformation requise est de l'ordre de 4,1% dans le cas d'une déformation uniaxiale, et de l'ordre de 1,5% dans le cas d'une déformation biaxiale.

De manière avantageuse, une pluralité de structures semiconductrices 1 peuvent être réalisées de manière simultanée à partir de la même couche semiconductrice 10. Les structures semiconductrices sont alors adjacentes et séparées les unes des autres. Ainsi, chaque structure semiconductrice est distincte de ses voisines, c'est-à-dire non rattachée à la partie périphérique correspondante de la même couche semiconductrice.

Les figures 6 et 7a à 7c illustrent un exemple de variante de structure semiconductrice 1 obtenue par le procédé selon le premier ou second mode de réalisation, dans laquelle des éléments de renfort 61 sont disposés au niveau de la portion contrainte 40, par exemple dans ou en bordure de celle-ci.

Sur la figure 6, la structure semiconductrice 1 est représentée schématiquement en vue de dessus. Elle est ici similaire à celle représentée sur la figure 3b et n'est donc pas décrite en détail. Elle s'en distingue néanmoins par la présence d'au moins un élément de renfort 61, ici une pluralité d'éléments, disposés au niveau de la portion contrainte 40, chacun étant adapté pour diminuer localement l'énergie élastique de la structure semiconductrice 1 sans pour autant diminuer sensiblement la déformation moyenne de la portion contrainte 40, et ainsi contribuer à assurer la tenue mécanique de celle-ci.

Plus précisément, dans cet exemple, les éléments de renfort 61 se présentent sous la forme d'une zone gravée 62 traversant la portion contrainte 40 sur toute son épaisseur et se poursuivant dans une partie de la couche support 30, remplie d'un matériau distinct de celui composant principalement la portion contrainte. Les éléments de renfort 61 s'étendent ainsi, d'une manière sensiblement orthogonale au plan (X,Y), suivant la direction d'épaisseur de la couche contrainte.

Les éléments de renfort 61 sont disposés ici dans la portion contrainte 40, c'est-à-dire qu'ils sont chacun entourés du matériau formant la portion contrainte, et sont situés ici au niveau de la bordure formant le raccord entre la portion contrainte 40 et les bras tenseurs 50.

Dans cet exemple, les éléments de renfort 61 présentent chacun un profil dans le plan (X,Y) de forme circulaire, mais d'autres profils sont possibles, par exemple de forme allongée, oblongue, polygonale ou autre. Le matériau de renfort est distinct de celui de la portion contrainte, et présente donc des propriétés mécaniques différentes susceptibles de renforcer la tenue mécanique de la structure semiconductrice. Il est ici choisi parmi un oxyde ou un nitrure, par exemple de silicium.

Par ailleurs, comme représenté dans cet exemple, les éléments de renfort 61 peuvent présenter une fonction optique, par exemple former un miroir de Bragg. Ainsi, deux miroirs de Bragg sont formés de part et d'autre de la portion contrainte 40 de manière à former une cavité optique dans laquelle la portion contrainte 40 est apte à former un milieu à gain d'une source d'émission de lumière cohérente.

Les figures 7a à 7c illustrent de manière schématique différentes étapes de réalisation des éléments de renfort. La figure 7a illustre une structure semiconductrice 1, ici obtenue à partir du procédé de réalisation selon le premier mode décrit précédemment, où une portion contrainte 40 de germanium est collée par adhérence moléculaire hydrophobe sur la couche support 30. On réalise ensuite au moins une zone gravée 62 (deux zones sont représentées) qui traversent la portion contrainte 40 sur toute son épaisseur et s'étend dans une partie de la couche support 30 (figure 7b). On remplit ensuite les zones gravées 62 par un matériau de renfort, ici un oxyde de silicium, qui remplit au moins en partie, et de préférence totalement, les zones gravées. Le matériau de renfort peut également recouvrir la structure semiconductrice 1 sous forme d'une couche d'encapsulation. La partie distale des portions latérales 50 est ensuite supprimée (figure 7c).

En variante (non représentée), les zones gravées 62 sont réalisées lors de l'étape illustrée sur la figure 1a de structuration de la couche semiconductrice 10 de manière à former la partie structurée 11 comportant la portion centrale 40 et les portions latérales 50, donc préalablement à l'étape de mise en contact de la partie structurée 11 avec la surface libre de la couche 30.

En variante, d'autres agencements des éléments de renfort sont possibles. Par exemple, les zones gravées de la portion contrainte peuvent être disposées au niveau des bordures latérales de la portion contrainte, sensiblement parallèles à l'axe de déformation, de manière à assurer également une fonction optique. Ainsi, en variante à l'exemple de la figure 6, les deux bordures latérales peuvent être gravées suivant une période prédéfinie, puis les zones gravées remplies d'un matériau différent de celui formant la portion contrainte et présentant un contraste d'indice optique avec celui-ci. Ainsi, chaque bordure latérale forme un réseau dans lequel un défaut de période peut être présent de manière à former une cavité en $\lambda/4$, où $\lambda$ est la longueur d'onde d'émission de la source de lumière comportant une telle portion contrainte à structurations latérales. Ainsi, les éléments de renfort forment ici une cavité optique de type DFB (pour *Distributed Feedback Laser,* en anglais).

On décrit maintenant la réalisation de différents dispositifs optoélectroniques comportant la structure semiconductrice 1 à portion contrainte obtenue par le procédé selon le premier ou second mode de réalisation décrit précédemment. A titre illustratif, les dispositifs optoélectroniques décrits par la suite comportent une structure semiconductrice en germanium monocristallin collée à une couche support en silicium.

Les figures 8a et 8b représentent de manière schématique une vue en coupe de deux exemples d'un dispositif optoélectronique à émission de lumière non cohérente. Plus précisément, le dispositif optoélectronique est ici une diode électroluminescente.

Sur la figure 8a, la diode électroluminescente comporte ici une structure semiconductrice 1 obtenue par le procédé de réalisation selon le second mode de réalisation, c'est-à-dire faisant intervenir un collage moléculaire hydrophile.

La structure semiconductrice 1 en germanium comporte une portion contrainte 40 mise en tension par des bras tenseurs 50. Elle est solidarisée à la couche support 30 par collage moléculaire hydrophile, ce qui se traduit par la présence d'un matériau intercalaire 14, ici un oxyde de silicium, situé à l'interface entre le germanium de la structure semiconductrice 1 et le silicium de la couche support 30. La couche support est ici une couche supérieure en silicium d'un substrat de type SOI. Elle repose sur une couche d'oxyde 32 située entre la couche support 30 et une couche inférieure 33 épaisse de silicium.

La structure semiconductrice 1 comporte en outre une couche d'encapsulation 63 qui recouvre la portion contrainte 40 et les bras tenseurs 50. La portion contrainte 40 comporte une jonction PIN réalisée par implantation de dopants (phosphore et bore, dans le cas du germanium) de manière à former une zone 41 dopée N voisine d'une zone 43 dopée P. Ici, une zone 42 intrinsèque (non intentionnellement dopée) sépare les zones 41, 43 dopées N et P. La jonction PIN s'étend de manière sensiblement verticale au-travers de la portion contrainte 40, en direction de la couche support. Par ailleurs, deux plots 64a, 64b d'un matériau électriquement conducteur sont présents au niveau des zones dopées 41, 43, formant des contacts électriques.

A titre d'exemple, la structure semiconductrice de germanium de la diode présente une épaisseur moyenne de 300nm. La portion contrainte présente une surface collée de l'ordre de quelques microns carrés, par exemple $1\mu m^2$, et une déformation moyenne biaxiale de 2% environ. Les bras tenseurs présentent une surface minimale collée de l'ordre de $305\mu m^2$. La structure semiconductrice est solidarisée par collage moléculaire hydrophile d'une valeur minimale de $1J/m^2$ obtenue à la suite d'un recuit de consolidation à une température de 200°C environ pendant une durée suffisante de quelques minutes à quelques heures.

La diode électroluminescente peut être obtenue de la manière suivante. On réalise tout d'abord la structure semiconductrice par le procédé selon le second mode de réalisation, puis on réalise les zones dopées par implantation d'impuretés, par exemple du phosphore et du bore dans le cas du germanium. Les contacts électriques sont ensuite réalisés. Une couche d'encapsulation est ensuite déposée puis aplanie par une technique de polissage mécano-chimique de type CMP (pour *Chemical Mechanical Polishing,* en anglais) puis localement gravée de manière à rendre accessibles les contacts électriques.

La figure 8b illustre une variante de la diode électroluminescente illustrée sur la figure 5a, qui s'en distingue essentiellement en ce qu'une jonction PIN s'étend de manière sensiblement parallèle au plan de la couche support.

La portion contrainte 40 est structurée dans son épaisseur, de manière à présenter une partie inférieure 43 dopée selon un premier type de conductivité, ici de type P, reposant sur la couche support 30. Cette partie 43 dopée P est reliée aux bras tenseurs 50 et présente une épaisseur moyenne sensiblement identique à celle des bras. Sur la partie inférieure dopée P repose une partie supérieure 41 dopée selon un second type de conductivité, ici de type N. Une partie intrinsèque 42 est située entre la partie supérieure 41 dopée N et la partie inférieure 43 dopée P, et présente ici des dimensions dans le plan (X,Y) sensiblement identiques à celles de la partie supérieure 41. Ainsi, les parties dopées P et N et la partie intrinsèque forment ensemble une jonction PIN qui s'étend suivant un plan sensiblement parallèle au plan (X,Y). Deux plots 64a, 64b d'un matériau électriquement conducteur, formant des contacts électriques, sont disposés sur la partie supérieure 41 dopée N et sur une zone libre de la partie inférieure 43 dopée P.

A titre d'exemple, la partie inférieure de la portion contrainte présente une épaisseur de l'ordre de 200nm, et un niveau de dopage de l'ordre de $2.10^{18}$ cm$^{-3}$. La partie intrinsèque présente une épaisseur ici de l'ordre de 100nm et la partie supérieure une épaisseur de l'ordre de 200nm et un niveau de dopage de l'ordre de $2.10^{18}$ cm$^{-3}$. La partie inférieure de la portion contrainte présente une surface collée de l'ordre de quelques microns carrés, par exemple 1$\mu$m$^2$, et la portion contrainte présente une déformation moyenne biaxiale de 2% environ. Les bras tenseurs présentent une surface collée de l'ordre de 300$\mu$m$^2$. La structure semiconductrice est solidarisée par collage moléculaire hydrophile d'une valeur minimale de 1J/m$^2$ obtenue à la suite d'un recuit de consolidation à une température de 200°C environ pendant une durée suffisante de quelques minutes à quelques heures.

Les parties dopées de la structure semiconductrice peuvent avoir été réalisées lors de la croissance épitaxiale de la couche semiconductrice de germanium lors de l'obtention de l'empilement tel que représenté sur la figure 1a. De manière alternative, elles peuvent être obtenues après réalisation de la structure semiconductrice par des étapes d'implantation des impuretés dopantes à différentes profondeurs.

Les figures 9a et 9b représentent de manière schématique une vue en coupe des exemples d'un dispositif optoélectronique à émission de lumière cohérente. Plus précisément, le dispositif optoélectronique est ici une source laser à pompage optique ou électrique.

Sur la figure 9a, la source laser comporte ici une structure semiconductrice 1 obtenue par le procédé de réalisation selon le second mode de réalisation, c'est-à-dire faisant intervenir un collage moléculaire hydrophile. La source laser comporte ici une structure semiconductrice 1 formée d'une portion contrainte 40 mise en tension par des bras tenseurs 50, et solidarisée à la couche support 30 par collage moléculaire hydrophile, ce qui se traduit par la présence d'un matériau intercalaire 14, 15 situé à l'interface entre le matériau de la structure semiconductrice 1 et celui de la couche support 30. La structure semiconductrice est ici en germanium et la couche support est ici une couche supérieure en silicium d'un substrat de type SOI. Elle repose sur une couche d'oxyde 32 située entre la couche support et une couche inférieure 33 épaisse de silicium. Le matériau intercalaire peut être un oxyde de silicium.

Le germanium de la structure semiconductrice est ici intrinsèque voire dopé, et une cavité optique est réalisée à l'intérieur de laquelle se situe la portion contrainte 40, qui forme ici un milieu à gain apte à émettre de la lumière. Pour cela, et à titre illustratif, deux miroirs de Bragg 65a, 65b sont disposés sur la face supérieure 52 des bras tenseurs 50, de préférence dans une zone où la déformation des bras tenseurs est sensiblement égale à la valeur résiduelle.

A titre d'exemple, la structure semiconductrice de germanium de la source laser présente une épaisseur moyenne de 300nm. La portion contrainte présente une surface collée de l'ordre de quelques microns carrés, par exemple 5$\mu$m$^2$, et une déformation moyenne uniaxiale de 5,7% environ. Les bras tenseurs présentent une surface minimale collée de l'ordre de 260$\mu$m$^2$. La structure semiconductrice est solidarisée par collage moléculaire hydrophile d'une valeur minimale de 1J/m$^2$ obtenue à la suite d'un recuit de consolidation à une température de 200°C environ pendant une durée suffisante de quelques minutes à quelques heures.

Le retrait partiel de matériau formant les portions latérales 50 lors de la réalisation des miroirs de Bragg 65a, 65b peut être pris en compte lors de l'étape de détermination préalable de la valeur minimale d'énergie surfacique de collage $E_s^{min}$ et la valeur minimale de surface collée $S_{bt}^{min}$ des bras tenseurs.

La figure 9b illustre une variante de la diode électroluminescente illustrée sur la figure 7a, qui s'en distingue essentiellement en ce qu'une jonction PIN s'étend de manière sensiblement parallèle au plan de la couche support dans la portion contrainte. La portion contrainte 40 comporte ici un empilement d'une première partie 43 inférieure, située à proximité de la couche support 30, dopée selon un premier type de conductivité, par exemple de type P, recouverte d'une partie intermédiaire 42 intrinsèque, elle-même recouverte d'une partie 41 dopée selon un second type de conductivité opposé au premier type, par exemple de type N. Une cavité optique, similaire à celle décrite en référence à la figure 7a, est réalisée au niveau de la face supérieure 52 des bras tenseurs 50. Par ailleurs, deux contacts électriques (non représentés) sont prévus pour être en contact l'un avec la partie supérieure dopée N et l'autre avec la partie inférieure dopée P. Ici également, le retrait partiel de matériau formant les portions latérales 50 lors de la réalisation des miroirs de Bragg 65a, 65b peut être pris en compte lors de l'étape de détermination préalable de la valeur minimale d'énergie surfacique de collage $E_s^{min}$ et la valeur minimale de surface collée $S_{bt}^{min}$ des bras tenseurs.

Les figures 10a à 10f représentent de manière schématique en vue en coupe différentes étapes d'un exemple de procédé de réalisation d'une source laser dans laquelle la cavité optique est réalisée au niveau de la couche support.

Dans cet exemple, on réalise, par exemple par épitaxie RP-CVD (pour *reduced pressure chemical vapor deposition,* en anglais), une couche 2 d'un matériau semiconducteur, ici du germanium, sur un substrat 3 de silicium (figure 10a). On recouvre ensuite la couche de germanium d'une couche d'oxyde 4 puis on implante des ions H+ dans la couche de germanium (trait pointillé sur la figure 10b).

On réalise ensuite une couche en silicium destinée à former la couche support 30, ici sous forme d'un substrat SOI, dans laquelle on réalise au niveau de sa surface 31, deux miroirs de Bragg 65a, 65b (ou des éléments optiques équivalents) destinés à former une cavité optique. La surface 31 de la couche support est ensuite recouverte d'une couche d'oxyde.

On solidarise le substrat SOI avec la surface de la couche d'oxyde 4 (figure 10c). On effectue la rupture de la couche de germanium 2 au niveau de la zone d'implantation d'ions et on obtient ainsi un empilement d'une couche semiconductrice 10 de germanium liée à une couche support 30 en silicium par l'intermédiaire d'une couche sacrificielle 20 en oxyde de silicium. Les deux miroirs de Bragg 65a, 65b sont enterrés dans la couche support 30 au niveau de l'interface avec la couche sacrificielle 20 (figure 10d).

On obtient ensuite une structure semiconductrice 1 à partir du procédé selon le second mode de réalisation. Les miroirs de Bragg 65a, 65b sont ainsi disposés en regard des bras tenseurs 50, voire en regard de la portion contrainte 40, et encadrent la portion contrainte 40 de manière à former une cavité optique (figure 10e). On dépose ensuite une couche d'encapsulation 63, par exemple en oxyde de silicium, qui recouvre la structure semiconductrice 1. On réalise enfin une jonction PIN 41, 42, 43 puis des contacts électriques 64a, 64b d'une manière similaire à celle décrite en référence à la figure 6a (figure 10f). Par ailleurs, la couche support peut avoir été préalablement structurée de manière à former le coeur d'un guide d'onde entourée d'une gaine formée par l'oxyde de silicium, le coeur s'étend sensiblement en regard de la portion contrainte.

Des modes de réalisation particuliers viennent d'être décrits. Différentes variantes et modifications apparaîtront à l'homme du métier.

Ainsi, les dispositifs optoélectroniques décrits précédemment le sont à titre uniquement illustratif. D'autres dispositifs optoélectroniques peuvent être réalisés, par exemple des sources laser à pompage optique ou électrique, avec jonctions PN, PIN, ou non, voire encore des diodes électroluminescentes ou des photodétecteurs.

**Revendications**

1. Procédé de réalisation d'une structure semiconductrice (1) comportant une portion contrainte (40) et solidaire d'une couche support (30) par collage moléculaire, comportant les étapes dans lesquelles :

    i. on fournit un empilement formé d'une couche semiconductrice (10) recouvrant une couche sacrificielle (20) disposée sur une couche support (30) ;
    ii. on structure la couche semiconductrice (10) de manière à former une partie structurée (11) et une partie périphérique (12), la partie structurée (11) comportant une portion centrale (40) reliée à la partie périphérique (12) par au moins deux portions latérales (50) opposées l'une à l'autre vis-à-vis de la portion centrale ;
    iii. on réalise une cavité (21) située sous la partie structurée (11) par gravure de la couche sacrificielle (20), de manière à rendre libre une surface (31) de la couche support (30) située au niveau de la cavité et à contraindre la portion centrale (40), dite portion contrainte, par les portions latérales (50), ainsi qu'une mise en contact de la partie structurée (11) avec ladite surface libre (31) de manière à rendre solidaire la partie structurée (11) de ladite surface libre (31) par collage moléculaire ;

    le procédé étant **caractérisé en ce que** :

    iv. on détermine une valeur minimale d'énergie de collage moléculaire de la partie structurée (11) sur la couche support (30), ainsi qu'une valeur minimale de surface collée des portions latérales (50) sur la couche support (30), ces valeurs minimales étant telles que ladite énergie de collage moléculaire est supérieure à une énergie élastique de la partie structurée (11) ;
    v. on effectue un recuit de consolidation à une température de recuit telle que l'énergie de collage moléculaire présente une valeur supérieure ou égale à ladite valeur minimale préalablement déterminée ;
    vi. on grave une partie distale (51) des portions latérales (50) vis-à-vis de la portion contrainte (40), de sorte que la surface collée des portions latérales (50) présente une valeur supérieure ou égale à ladite valeur minimale préalablement déterminée, obtenant ainsi ladite structure semiconductrice.

2. Procédé de réalisation selon la revendication 1, dans lequel, lors de l'étape vi, on grave une partie distale (51) des portions latérales (50) formant raccord avec la partie périphérique (12) de la couche semiconductrice (10).

3. Procédé de réalisation selon l'une quelconque des revendications précédentes, dans lequel, à la suite de l'étape vi, la structure semiconductrice (1) présente une face supérieure opposée à la couche support (30) sensiblement plane.

4. Procédé de réalisation selon l'une quelconque des revendications précédentes, comportant en outre les étapes suivantes :

- préalablement à l'étape i) de fourniture, estimation d'une valeur minimale $\left(\sigma_{pc}^{f,min}\right)$ de contrainte en tension à partir de laquelle la couche semiconductrice (10) présente une structure de bandes d'énergie directe ($\Delta E \geq 0$) ;

- fourniture dudit empilement, la couche semiconductrice (10) présentant une valeur initiale $\left(\sigma_{pc}^{i}\right)$ inférieure à ladite valeur minimale $\left(\sigma_{pc}^{f,min}\right)$ ;

- détermination de la structuration de sorte que, après l'étape iii) de réalisation de la cavité, la portion centrale (40) présente une valeur finale $\left(\sigma_{pc}^{f}\right)$ de contrainte en tension supérieure ou égale à ladite valeur minimale $\left(\sigma_{pc}^{f,min}\right)$ et donc une structure de bandes d'énergie directe ($\Delta E \geq 0$).

5. Procédé de réalisation selon l'une quelconque des revendications 1 à 4, dans lequel, lors de l'étape de fourniture, la couche semiconductrice (10) présente une contrainte en tension d'une valeur initiale $\left(\sigma_{pc}^{i}\right)$ non nulle, et, lors de l'étape de structuration, les portions latérales (50) présentent une largeur moyenne supérieure à une largeur moyenne de la portion centrale (40).

6. Procédé de réalisation selon l'une quelconque des revendications 1 à 5, dans lequel, lors de l'étape iii on réalise la cavité (21) et la mise en contact par gravure par HF en phase vapeur éventuellement suivie par le dépôt puis l'évaporation d'un liquide au niveau de la cavité, et dans lequel, lors de l'étape v la température de recuit est sensiblement supérieure ou égale à 200°C.

7. Procédé de réalisation selon l'une quelconque des revendications 1 à 5, dans lequel, lors de l'étape iii on réalise une oxydation ou une nitruration de ladite surface libre (31) et d'une surface de la partie structurée (11) orientée vers la surface libre, et dans lequel, lors de l'étape v la température de recuit est sensiblement supérieure ou égale à 100°C.

8. Procédé de réalisation selon la revendication précédente, dans lequel une couche diélectrique (14, 15) issue de ladite oxydation ou nitruration est formée à l'interface entre la partie structurée (11) et la couche support (30), dont l'épaisseur est de préférence supérieure ou égale à 10nm.

9. Procédé de réalisation selon l'une quelconque des revendications précédentes, dans lequel, lors de l'étape ii, on structure les portions latérales (50) de sorte que, lors de l'étape iii, la portion contrainte (40) présente une déformation uniaxiale ou biaxiale.

10. Procédé de réalisation selon l'une quelconque des revendications précédentes, dans lequel la portion contrainte (40) comporte au moins une partie dopée (41, 43) avec un niveau de dopage supérieur ou égal à $2.10^{18}$ cm$^{-3}$.

11. Procédé de réalisation selon l'une quelconque des revendications précédentes, dans lequel, on réalise au moins un élément de renfort (61) situé au niveau de la portion contrainte (40), ledit élément de renfort comportant un matériau distinct du matériau formant la portion contrainte, et s'étendant sur toute l'épaisseur de la portion contrainte (40) et dans une partie de la couche support (30).

12. Procédé de réalisation collective d'une pluralité de structures semiconductrices adjacentes et distinctes les unes des autres, dans lequel on réalise de manière simultanée lesdites structures semiconductrices par le procédé de réalisation selon l'une quelconque des revendications précédentes, et dans lequel on sépare chaque structure semiconductrice (1) de la partie périphérique (12) correspondante.

**13.** Procédé de réalisation d'un dispositif optoélectronique, ledit dispositif comportant une structure semiconductrice obtenue par le procédé selon l'une quelconque des revendications 1 à 11, dans lequel on réalise une jonction PN ou PIN (41, 42, 43) dans la portion contrainte (40), la jonction s'étendant de manière sensiblement orthogonale ou parallèle au plan de la couche support.

**14.** Procédé de réalisation d'un dispositif optoélectronique, ledit dispositif comportant une structure semiconductrice obtenue par le procédé selon l'une quelconque des revendications 1 à 11, dans lequel on réalise une cavité optique dans laquelle est située au moins une partie de la portion contrainte (40) dont le matériau est adapté à former un milieu à gain, le dispositif obtenue étant adapté à émettre un faisceau lumineux cohérent.

**15.** Procédé de réalisation d'un dispositif optoélectronique selon la revendication 14, dans lequel on réalise au moins deux éléments optiques réflecteurs (65a, 65b) adaptés à former la cavité optique, les éléments optiques étant disposés au niveau d'une face supérieure (52) de la structure semiconductrice opposée à la couche support, ou dans lequel on réalise au moins deux éléments optiques réflecteurs (65a, 65b) adaptés à former la cavité optique, les éléments optiques étant disposés au niveau de la surface libre (31) de la couche support (30).

**Patentansprüche**

**1.** Verfahren zur Herstellung einer Halbleiterstruktur (1), die einen Spannabschnitt (40) aufweist und mit einer Trägerschicht (30) durch Molekularkleben fest verbunden ist, das die folgenden Schritte aufweist:

i. Bereitstellen eines Stapels, der aus einer Halbleiterschicht (10) gebildet ist, die eine Opferschicht (20) bedeckt, die auf einer Trägerschicht (30) angeordnet ist;
ii. Strukturieren der Halbleiterschicht (10) derart, dass ein strukturierter Teil (11) und ein peripherer Teil (12) gebildet wird, wobei der strukturierte Teil (11) einen Mittelabschnitt (40) aufweist, der mit dem peripheren Teil (12) durch mindestens zwei Seitenabschnitte (50) verbundenen ist, die einander gegenüber dem Mittelabschnitt (40) gegenüberliegen;
iii. Herstellen eines Hohlraums (21), der unter dem strukturierten Teil (11) angeordnet ist, durch Ätzen der Opferschicht (20) derart, dass eine Oberfläche (31) der Trägerschicht (30), die auf der Höhe des Hohlraums angeordnet ist, freigelegt wird und dass der Mittelabschnitt (40), der Spannabschnitt genannt wird, durch die Seitenabschnitte (50) gespannt wird, und auch ein Inkontaktbringen des strukturierten Teils (11) mit der freien Oberfläche (31) derart, dass der strukturierte Teil (11) mit der freien Fläche (31) durch Molekularkleben fest verbunden wird;

wobei das Verfahren **dadurch gekennzeichnet ist, dass**:

iv. ein minimaler Energiewert des Molekularklebens des strukturierten Teils (11) auf die Trägerschicht (30) und ein minimaler Wert der geklebten Oberfläche der Seitenabschnitte (50) auf die Trägerschicht (30) bestimmt wird, wobei diese minimalen Werte derart sind, dass die Energie des Molekularklebens größer als eine elastische Energie des strukturierten Teils (11) ist;
v. ein Verfestigungsglühens bei einer derartigen Glühtemperatur durchgeführt wird, dass die Energie des Molekularklebens einen Wert aufweist, der größer als oder gleich dem zuvor bestimmten minimalen Wert ist;
vi. ein distaler Teil (51) der Seitenabschnitte (50) gegenüber von dem Spannabschnitt (40) derart geätzt wird, dass die geklebte Oberfläche der Seitenabschnitte (50) einen Wert aufweist, der größer als oder gleich dem zuvor bestimmten minimalen Wert ist, wodurch auf diese Weise eine Halbleiterstruktur erhalten wird.

**2.** Verfahren zur Herstellung nach Anspruch 1, wobei bei dem Schritt vi ein distaler Teil (51) der Seitenabschnitte (50) geätzt wird, der eine Verbindung mit dem peripheren Teil (12) der Halbleiterschicht (10) bildet.

**3.** Verfahren zur Herstellung nach einem der vorhergehenden Ansprüche, wobei die Halbleiterstruktur (1) nach dem Schritt vi eine obere Fläche aufweist, die der Trägerschicht (30) gegenüberliegt, die im Wesentlichen eben ist.

**4.** Verfahren zur Herstellung nach einem der vorhergehenden Ansprüche, ferner umfassend die folgenden Schritte:

- vor dem Schritt i) des Bereitstellens, Schätzen eines minimalen Endwertes $\left(\sigma_{pc}^{f,min}\right)$ der Zugspannung, ab dem die Halbleiterschicht (10) eine direkte Energiebandstruktur ($\Delta E \geq 0$) aufweist;

- Bereitstellen des Stapels, wobei die Halbleiterschicht (10) einen Anfangswert $\left(\sigma_{pc}^i\right)$ aufweist, der niedriger als der Minimalwert $\left(\sigma_{pc}^{f,min}\right)$ ist;

- Bestimmen der Strukturierung derart, dass der Mittelabschnitt (40) nach dem Schritt iii) des Herstellens des Hohlraums einen Endwert $\left(\sigma_{pc}^f\right)$ der Zugspannung, der größer als oder gleich dem Mindestwert $\left(\sigma_{pc}^{f,min}\right)$ ist, und somit eine direkte Energiebandstruktur ($\Delta E \geq 0$) aufweist.

5. Verfahren zur Herstellung nach einem der Ansprüche 1 bis 4, wobei die Halbleiterschicht (10) bei dem Schritt des Bereitstellens eine Zugspannung eines von Null verschiedenen Anfangswertes $\left(\sigma_{pc}^i\right)$ aufweist, und die Seitenabschnitte (50) bei dem Schritt der Strukturierung eine mittlere Breite aufweisen, die größer als eine mittlere Breite des Mittelabschnitts (40) ist.

6. Verfahren zur Herstellung nach einem der Ansprüche 1 bis 5, wobei bei dem Schritt iii der Hohlraum (21) hergestellt und das Inkontaktbringen durch HF-Ätzung in der Dampfphase durchgeführt wird, auf das eventuell das Abscheiden und dann das Verdampfen einer Flüssigkeit auf Ebene des Hohlraums folgt, und wobei bei dem Schritt v die Glühtemperatur im Wesentlichen mehr als oder gleich 200°C beträgt.

7. Verfahren zur Herstellung nach einem der Ansprüche 1 bis 5, wobei bei dem Schritt iii ein Oxidieren oder ein Nitrieren der freien Oberfläche (31) und einer Oberfläche des strukturierten Teils (11), der zu der freien Oberfläche gerichtet ist, durchgeführt wird, und wobei bei dem Schritt v die Glühtemperatur im Wesentlichen mehr als oder gleich 100°C beträgt.

8. Verfahren zur Herstellung nach dem vorhergehenden Anspruch, wobei eine dielektrische Schicht (14, 15), die aus dem durchgeführten Oxidieren oder Nitrieren hervorgegangen ist, an der Schnittstelle zwischen dem strukturierten Teil (11) und der Trägerschicht (30) gebildet wird, deren Dicke vorzugsweise größer als oder gleich 10nm ist.

9. Verfahren zur Herstellung nach einem der vorhergehenden Ansprüche, wobei bei dem Schritt ii die Seitenabschnitte (50) derart strukturiert werden, dass der Spannabschnitt (40) bei dem Schritt iii eine uniaxiale oder biaxiale Verformung aufweist.

10. Verfahren zur Herstellung nach einem der vorhergehenden Ansprüche, wobei der Spannabschnitt (40) mindestens einen dotierten Teil (41, 43) mit einem Dotierungsniveau von über oder gleich $2,10^{18}$cm$^{-3}$ aufweist.

11. Verfahren zur Herstellung nach einem der vorhergehenden Ansprüche, wobei mindestens ein Verstärkungselement (61) hergestellt wird, das sich auf der Höhe des Spannabschnitts (40) befindet, wobei das Verstärkungselement ein Material aufweist, das von dem Material verschieden ist, das den Spannabschnitt bildet, und sich über die gesamte Dicke des Spannabschnitts (40) und in einen Teil der Trägerschicht (30) erstreckt.

12. Verfahren zur kollektiven Herstellung von mehreren benachbarten und voneinander verschiedenen Halbleiterstrukturen, wobei die Halbleiterstrukturen gleichzeitig von dem Verfahren zur Herstellung nach einem der vorhergehenden Ansprüche hergestellt werden und wobei jede Halbleiterstruktur (1) von dem entsprechenden peripheren Teil (12) getrennt wird.

13. Verfahren zur Herstellung einer optoelektronischen Vorrichtung, wobei die Vorrichtung eine Halbleiterstruktur aufweist, die nach dem Verfahren nach einem der Ansprüche 1 bis 11 erhalten wird, wobei ein pn- oder pin-Übergang (41, 42, 43) in dem Spannabschnitt (40) hergestellt wird, wobei sich der Übergang im Wesentlichen orthogonal oder parallel zu der Ebene der Trägerschicht erstreckt.

14. Verfahren zur Herstellung einer optoelektronischen Vorrichtung, wobei die Vorrichtung eine Halbleiterstruktur aufweist, die nach dem Verfahren nach einem der Ansprüche 1 bis 11 erhalten wird, wobei ein optischer Hohlraum hergestellt wird, in dem sich mindestens ein Teil des Spannabschnitts (40) befindet, dessen Material geeignet ist, ein Verstärkungsmedium zu bilden, wobei die erhaltene Vorrichtung geeignet ist, einen kohärenten Lichtstrahl auszusenden.

**15.** Verfahren zur Herstellung einer optoelektronischen Vorrichtung nach Anspruch 14, wobei mindestens zwei optische Reflektorelemente (65a, 65b) hergestellt werden, die geeignet sind, einen optischen Hohlraum zu bilden, wobei die optischen Elemente an einer oberen Fläche (52) der Halbleiterstruktur angeordnet sind, die der Trägerschicht gegenüberliegt, oder wobei mindestens zwei optische Reflektorelemente (65a, 65b) hergestellt werden, die geeignet sind, den optischen Hohlraum zu bilden, wobei die optischen Elemente an der freien Oberfläche (31) der Trägerschicht (30) angeordnet sind.

**Claims**

**1.** Method of production of a semiconducting structure (1) comprising a strained portion (40) tied to a support layer (30) by molecular bonding, comprising the steps in which:

i. a stack is provided, formed of a semiconducting layer (10) covering a sacrificial layer (20) disposed on a support layer (30);
ii. the semiconducting layer (10) is structured in such a way as to form a structured part (11) and a peripheral part (12), the structured part (11) comprising a central portion (40) linked to the peripheral part (12) by at least two lateral portions (50) opposite one another in relation to the central portion;
iii. a cavity (21) situated under the structured part (11) is produced by etching of the sacrificial layer (20), so as to render free a surface (31) of the support layer (30) situated at the level of the cavity and to strain the central portion (40), termed the strained portion, by the lateral portions (50), and the structured part (11) is placed in contact with said free surface (31) so as to bind the structured part (11) of said free surface (31) by molecular bonding;

the method being **characterized in that**:

iv. a minimum value of molecular bonding energy of the structured part (11) on the support layer (30) is determined, together with a minimum value of bonded area of the lateral portions (50) on the support layer (30), these minimum values being such that said molecular bonding energy is greater than an elastic energy of the structured part (11);
v. a consolidation annealing is performed at an annealing temperature such that the molecular bonding energy exhibits a value greater than or equal to said previously determined minimum value;
vi. a distal part (51) of the lateral portions (50) in relation to the strained portion (40) is etched, so that the bonded area of the lateral portions (50) exhibits a value greater than or equal to said previously determined minimum value, thus obtaining said semiconducting structure.

**2.** Method of production according to Claim 1, in which, during step vi, a distal part (51) of the lateral portions (50) joining with the peripheral part (12) of the semiconducting layer (10) is etched.

**3.** Method of production according to either of the preceding claims, in which, subsequent to step vi, the semiconducting structure (1) exhibits a substantially plane upper face opposite to the support layer (30).

**4.** Method of production according to any one of the preceding claims, furthermore comprising the following steps:

- prior to step i) of provision, estimation of a minimum value $\left(\sigma_{pc}^{f,min}\right)$ of tensile strain from which the semiconducting layer (10) exhibits a direct energy band structure ($\Delta E \geq 0$);

- provision of said stack, the semiconducting layer (10) exhibiting an initial value $\left(\sigma_{pc}^{i}\right)$ lower than said minimum value $\left(\sigma_{pc}^{f,min}\right)$;

- determination of the structuring so that, after step iii) of producing the cavity, the central portion (40) exhibits a final value $\left(\sigma_{pc}^{f}\right)$ of tensile strain greater than or equal to said minimum value $\left(\sigma_{pc}^{f,min}\right)$ and therefore a direct energy band structure ($\Delta E \geq 0$).

**5.** Method of production according to any one of Claims 1 to 4, in which, during the provision step, the semiconducting layer (10) exhibits a tensile strain of a non-zero initial value $\left(\sigma_{pc}^{i}\right)$ and, during the structuring step, the lateral portions (50) exhibit a greater average width than an average width of the central portion (40).

6. Method of production according to any one of Claims 1 to 5, in which, during step iii, the cavity (21) is produced and contact is carried out by HF vapor-phase etching optionally followed by the deposition and then the evaporation of a liquid at the level of the cavity, and in which, during step v the annealing temperature is substantially greater than or equal to 200°C.

7. Method of production according to any one of Claims 1 to 5, in which, during step iii, an oxidation or a nitriding of said free surface (31) and of a surface of the structured part (11) oriented toward the free surface is carried out, and in which, during step v, the annealing temperature is substantially greater than or equal to 100°C.

8. Method of production according to the preceding claim, in which a dielectric layer (14, 15) arising from said oxidation or nitriding is formed at the interface between the structured part (11) and the support layer (30), whose thickness is preferably greater than or equal to 10nm.

9. Method of production according to any one of the preceding claims, in which, during step ii, the lateral portions (50) are structured so that, during step iii, the strained portion (40) exhibits a uniaxial or biaxial deformation.

10. Method of production according to any one of the preceding claims, in which the strained portion (40) comprises at least one doped part (41, 43) with a doping level of greater than or equal to $2.10^{18}$ cm$^{-3}$.

11. Method of production according to any one of the preceding claims, in which, at least one reinforcement element (61) is produced situated at the level of the strained portion (40), said reinforcement element comprising a material distinct from the material forming the strained portion, and extending over the entire thickness of the strained portion (40) and in a part of the support layer (30).

12. Method of collective production of a plurality of mutually distinct and adjacent semiconducting structures, in which said semiconducting structures are produced in a simultaneous manner by the method of production according to any one of the preceding claims, and in which each semiconducting structure (1) is separated from the corresponding peripheral part (12).

13. Method for producing an optoelectronic device, said device comprising a semiconducting structure obtained by the method according to any one of Claims 1 to 11, in which a PN or PIN junction (41, 42, 43) is produced in the strained portion (40), the junction extending in a manner substantially orthogonal or parallel to the plane of the support layer.

14. Method for producing an optoelectronic device, said device comprising a semiconducting structure obtained by the method according to any one of Claims 1 to 11, in which an optical cavity is produced in which is situated at least one part of the strained portion (40) whose material is suitable for forming a gain medium, the device obtained being suitable for emitting a coherent light beam.

15. Method for producing an optoelectronic device according to Claim 14, in which at least two reflector optical elements (65a, 65b) suitable for forming the optical cavity are produced, the optical elements being disposed at the level of an upper face (52) of the semiconducting structure opposite to the support layer, or in which at least two reflector optical elements (65a, 65b) suitable for forming the optical cavity are produced, the optical elements being disposed at the level of the free surface (31) of the support layer (30).

**Fig.1a**

**Fig.1b**

**Fig.1c**

**Fig.1d**

**Fig.2a**

**Fig.2b**

**Fig.3a**

**Fig.3b**

**Fig.4**

Fig.5a

Fig.5b

Fig.5c

Fig.5d

Fig.5e

**Fig.6**

**Fig.7a**

**Fig.7b**

**Fig.7c**

**Fig.8a**

**Fig.8b**

Fig.9a

Fig.9b

**Fig.10a**

**Fig.10b**

**Fig.10c**

**Fig.10d**

**Fig.10e**

**Fig.10f**

110

$$\left\{\sigma_{pc}^{f,min} > 0\right\} / \Delta E \geq 0$$

120

$$\left\{\sigma_{pc}^{f,min} > \sigma_{pc}^{i} > 0\right.$$

130

$$F / \begin{cases} \sigma_{pc}^{f} = F\left(\sigma_{pc}^{i}\right) \\ \sigma_{pc}^{f} \geq \sigma_{pc}^{f,min} \end{cases}$$

140

$$\left\{\sigma_{pc}^{i} \rightarrow \left\{\sigma_{pc}^{f} = F(\sigma_{pc}^{i}) \geq \sigma_{pc}^{f,min}\right.\right.$$

**Fig.11**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **SUKHDEO et al.** Direct bandgap germanium-on-silicon inferred from 5,7% <100> uniaxial tensile strain. *Photon. Res.,* 2014, vol. 2 (3), A8
- **BOTZUG et al.** Grating-coupled mis-infrared light émission from tensilely strained germanium nanomembranes. *Applied Physics Letters,* 2013, vol. 103 (201114
- Structural and optical properties of 200 mm germanium-on-insulator (GeOI) substrates for silicon photonics applications. **REBOUD et al.** Proc. SPIE 9367. Silicon Photonics X, 27 Février 2015
- **JAN et al.** Tensile-strained germanium-on-insulator substrate for silicon-compatible optoelectronics. *Opt. Mater. Express,* 2011, vol. 1, 1121-1126
- **SÜESS et al.** Analysis of enhanced light emission from highly strained germanium microbridges. *Nature Photon.,* 2013, vol. 7, 466-472